# EUROPEAN PATENT APPLICATION

(11) **EP 4 764 947 A1**
(43) Date of publication of application: **24.06.2026**
(21) Application number: 25202520.0
(22) Date of filing: 16.09.2025
(51) Int. Cl.: G06N 3/006, G06N 20/00, G06N 3/0475, G06N 3/092

(54) **METHODS AND SYSTEMS FOR CONSTRUCTNG AND SIMULATING A DIGITAL TWIN OF PHYSICAL MODEL**

(30) Priority: 17.12.2024 IN 202421099989
(71) Applicant: Tata Consultancy Services Limited, Mumbai, Maharashtra 400 021 (IN)
(72) Inventor: YADAV, Abhishek, 226010 Lucknow, Uttar Pradesh (IN); THOGARU, Himabindu, 500034 Hyderabad, Telangana (IN); BARAT, Souvik, 411057 Pune, Maharashtra (IN); KULKARNI, Vinay, 411057 Pune, Maharashtra (IN); BHATTACHARYA, Kaustav, 600113 Chennai, Tamil Nadu (IN)
(74) Representative: Goddar, Heinz J.

(57) **Abstract**

The disclosure generally relates to methods and systems for constructing and simulating a digital twin of physical model. Conventional techniques employ a wide range of optimization techniques for flawless and timely delivery. However, these locally optimal solutions fail to ensure global robustness and flexibility for the entire network. The methods and systems of the present disclosure advocates for a paradigm shift from focusing on localized contexts to the entire parcel network to impart adaptiveness and resilience. The extended form of agent / actor formalism is employed to implement digital twin of the physical model (i.e., composite digital twin) as a set of autonomous interacting agents. The simulatable nature of the digital twin of the present disclosure facilitates in-silico experiments at various levels, ensuring both local and global properties. This empowers stakeholders to understand the bottlenecks, explore alternative future scenarios, devise strategies to reduce bottlenecks, and prevent undesired future situations.

## Description

### CROSS-REFERENCE TO RELATED APPLICATIONS AND PRIORITY

The present application claims priority to Indian application no. 202421099989, filed on December 17, 2024

### TECHNICAL FIELD

The disclosure herein generally relates to warehousing management, and, more particularly, to methods and systems for constructing and simulating a digital twin of a physical model for the supply chain companies.

### BACKGROUND

Supply chain companies such as postal delivery companies handle a significant volume of parcels, often in the magnitude of millions per day, transporting them from senders to receivers across vast geographical expanses. These companies make use of suitable physical models or networks for handling this huge volume of items. For example, the operation of the postal delivery companies is managed through a sophisticated network called a Parcel Delivery Network (PDN), comprising strategically positioned facilities like collection centers, distribution centers, sorting terminals, and hubs, interconnected along predefined paths.

These contemporary organizations face a significant surge in demand that comes with increased customer expectations for flawless and timely delivery in a shrinking window of opportunity to be met in an increasingly competitive world while facing a variety of micro and macro level uncertainties. Current industry practice relying on localized analysis to meet these expectations has turned out ineffective. Conventional techniques employ a wide range of optimization techniques for flawless and timely delivery. However, these locally optimal solutions fail to ensure global robustness and flexibility for the entire network. Moreover, such solutions often fail to scale for the desired demand and typically are not cognizant of the inherent heterogeneity and uncertainty. Conventional advanced techniques such as artificial intelligence (AI)-powered data-centric approaches produce ineffective solutions when: (i) the available data is limited, (ii) the context is dynamic (thus posing a challenge on relevancy of data), and (iii) faced with unforeseen scenarios.

### SUMMARY

Embodiments of the present disclosure present technological improvements as solutions to one or more of the above-mentioned technical problems recognized by the inventors in conventional systems.

In an aspect, a processor-implemented method for constructing and simulating a digital twin of physical model is provided. The method comprising: receiving a domain knowledge, one or more company specific datasets, and one or more company specific documents associated with a physical model of a company, from a resource repository, wherein the domain knowledge comprises one or more domain knowledge resource documents and one or more insight documents; constructing an agent meta model of the physical model from the domain knowledge using an agent-based modelling framework, wherein the agent meta model of the physical model comprises (i) one or more components, (ii) one or more subcomponents associated with each of the one or more components, and (iii) one or more relationships between the one or more components and between the one or more subcomponents associated with each of the one or more components; constructing a digital twin of the physical model by instantiating and populating the agent meta model of the physical model, using the one or more company specific datasets, wherein the digital twin of the physical model comprises (i) the one or more components with one or more component values, (ii) the one or more subcomponents associated with each of the one or more components along with one or more sub component values, and (iii) the one or more relationships between the one or more components and between the one or more subcomponents associated with each of the one or more components along with the one or more relationship values; validating a structure of the digital twin of the physical model through one or more automated structural validation techniques, to obtain a validated digital twin of the physical model; synchronizing the validated digital twin of the physical model with a current status data of the physical model, to obtain a synchronized digital twin of the physical model; and simulating the synchronized digital twin of the physical model with one or more simulation scenarios, using a trained reinforcement learning (RL) agent, wherein the one or more simulation scenarios are associated with one or more target goals of the physical model.

In another aspect, a system for constructing and simulating a digital twin of physical model is provided. The system includes: a memory storing instructions; one or more Input/Output (I/O) interfaces; and one or more hardware processors coupled to the memory via the one or more I/O interfaces, wherein the one or more hardware processors are configured by the instructions to: receive a domain knowledge, one or more company specific datasets, and one or more company specific documents associated with a physical model of a company, from a resource repository, wherein the domain knowledge comprises one or more domain knowledge resource documents and one or more insight documents; construct an agent meta model of the physical model from the domain knowledge using an agent-based modelling framework, wherein the agent meta model of the physical model comprises (i) one or more components, (ii) one or more subcomponents associated with each of the one or more components, and (iii) one or more relationships between the one or more components and between the one or more subcomponents associated with each of the one or more components; construct a digital twin of the physical model by instantiating and populating the agent meta model of the physical model, using the one or more company specific datasets, wherein the digital twin of the physical model comprises (i) the one or more components with one or more component values, (ii) the one or more subcomponents associated with each of the one or more components along with one or more sub component values, and (iii) the one or more relationships between the one or more components and between the one or more subcomponents associated with each of the one or more components along with the one or more relationship values; validate a structure of the digital twin of the physical model through one or more automated structural validation techniques, to obtain a validated digital twin of the physical model; synchronize the validated digital twin of the physical model with a current status data of the physical model, to obtain a synchronized digital twin of the physical model; and simulate the synchronized digital twin of the physical model with one or more simulation scenarios, using a trained reinforcement learning (RL) agent, wherein the one or more simulation scenarios are associated with one or more target goals of the physical model.

In yet another aspect, there are provided one or more non-transitory machine-readable information storage mediums comprising one or more instructions which when executed by one or more hardware processors cause: receiving a domain knowledge, one or more company specific datasets, and one or more company specific documents associated with a physical model of a company, from a resource repository, wherein the domain knowledge comprises one or more domain knowledge resource documents and one or more insight documents; constructing an agent meta model of the physical model from the domain knowledge using an agent-based modelling framework, wherein the agent meta model of the physical model comprises (i) one or more components, (ii) one or more subcomponents associated with each of the one or more components, and (iii) one or more relationships between the one or more components and between the one or more subcomponents associated with each of the one or more components; constructing a digital twin of the physical model by instantiating and populating the agent meta model of the physical model, using the one or more company specific datasets, wherein the digital twin of the physical model comprises (i) the one or more components with one or more component values, (ii) the one or more subcomponents associated with each of the one or more components along with one or more sub component values, and (iii) the one or more relationships between the one or more components and between the one or more subcomponents associated with each of the one or more components along with the one or more relationship values; validating a structure of the digital twin of the physical model through one or more automated structural validation techniques, to obtain a validated digital twin of the physical model; synchronizing the validated digital twin of the physical model with a current status data of the physical model, to obtain a synchronized digital twin of the physical model; and simulating the synchronized digital twin of the physical model with one or more simulation scenarios, using a trained reinforcement learning (RL) agent, wherein the one or more simulation scenarios are associated with one or more target goals of the physical model.

In an embodiment, constructing the agent meta model of the physical model from the domain knowledge using an agent-based modelling framework, comprises: identifying (i) the one or more components and (ii) the one or more subcomponents associated with each of the one or more components associated with the physical model, from the domain knowledge; extracting the one or more relationships between (i) the one or more components, and (ii) the one or more subcomponents associated with each of the one or more components, from the domain knowledge; and constructing the agent meta model of the physical model from (i) the one or more components, (ii) the one or more subcomponents associated with each of the one or more components, and (iii) the one or more relationships between the one or more components, and the one or more subcomponents associated with each of the one or more components, using the agent-based modelling framework.

In an embodiment, constructing the digital twin of the physical model by instantiating and populating the agent meta model of the physical model, comprises: instantiating each of (i) the one or more components, (ii) the one or more sub-components, and (iii) the one or more relationships, at a time, in a sequential process; extracting (i) one or more component property values for each of the one or more components, (ii) one or more sub-component property values for each of the one or more sub-components, and (iii) a relationship value for each of the one or more relationships, from the one or more company specific datasets and the one or more company specific documents, using a pre-configured large language model (LLMs); and populating (i) the one or more component property values for each of the one or more components, (ii) the one or more sub-component property values for each of the one or more sub-components, and (iii) the relationship value for each of the one or more relationships, into the agent meta model of the physical model, to obtain the digital twin of the physical model.

In an embodiment, validating the structure of the digital twin of the physical model through one or more automated structural validation techniques, comprises: receiving a target structure and a target integrity of the physical model, from a repository; defining a set of validation rules related to (i) the target structure and the target integrity of the physical model, and (ii) the one or more relationships between the one or more components and between the one or more subcomponents associated with each of the one or more components, using the agent meta model of the physical model; and validating the structure of the digital twin of the physical model using the set of validation rules through one or more automated structural validation techniques, to obtain the validated digital twin of the physical model.

In an embodiment, synchronizing the validated digital twin of the physical model with the current status data of the physical model, comprises: receiving the current status data of the physical model, wherein the current status data is associated with one or more parameters of the physical model; and initializing the validated digital twin of the physical model with the current status data, to obtain the synchronized digital twin of the physical model.

In an embodiment, the trained RL agent is obtained by: generating one or more lever setting-KPI pairs using the validated digital twin of the physical model, wherein each of the plurality of lever setting-KPI pairs comprises one or more lever settings of the physical model and one or more associated KPIs; training a first regression model and a second regression model, using the one or more lever setting-KPI pairs, to obtain a dynamics model and a policy model respectively, wherein the dynamics model is configured to take the one or more lever settings of the physical model and predict the one or more associated KPIs as output, and the policy model is configured to take the one or more associated KPIs as input and predict the one or more lever settings of the physical model as output; and training an RL agent using the dynamics model and the policy model, to obtain the trained reinforcement learning agent.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this disclosure, illustrate exemplary embodiments and, together with the description, serve to explain the disclosed principles:
FIG. 1A shows an exemplary physical model of a conventional parcel delivery network.
FIG. 1B shows an exemplary visual representation of a typical facility (F) of the physical model of the conventional parcel delivery network as shown in FIG. 1A.
FIG. 2 is an exemplary block diagram of a system for creating and simulating a digital twin of physical model, in accordance with some embodiments of the present disclosure.
FIGS. 3A and 3B illustrate exemplary flow diagrams of a processor-implemented method for creating and simulating a digital twin of physical model, using the system of FIG. 2, in accordance with some embodiments of the present disclosure.
FIG. 4A shows an exemplary agent metamodel in accordance with some embodiments of the present disclosure.
FIG. 4B shows a schematic view of an exemplary agent topology of the PDN in accordance with some embodiments of the present disclosure.
FIG. 4C shows exemplary agent interactions between the agents of the PDN in accordance with some embodiments of the present disclosure.
FIG. 4D shows exemplary agent interactions of the facility agent of the PDN in accordance with some embodiments of the present disclosure.
FIG. 5 is a flow diagram showing steps for constructing the agent meta model of the physical model from the domain knowledge using an agent-based modelling framework, in accordance with some embodiments of the present disclosure.
FIG. 6 is a flow diagram showing steps for constructing the digital twin of the physical model by instantiating and populating the agent meta model of the physical model, in accordance with some embodiments of the present disclosure.
FIG. 7 is a flow diagram showing steps for validating the structure of the digital twin of the physical model through one or more automated structural validation techniques, in accordance with some embodiments of the present disclosure.
FIG. 8 is a flow diagram showing steps for synchronizing the validated digital twin of the physical model, in accordance with some embodiments of the present disclosure.
FIG. 9 is a flow diagram showing steps for obtaining the trained RL agent, in accordance with some embodiments of the present disclosure.
FIG. 10 is a schematic view of the digital twin of the physical model along with simulation approach, in accordance with some embodiments of the present disclosure.
FIG. 11A is a graph showing parcel dwell time comparison of as-is and scenario 1, in accordance with some embodiments of the present disclosure.
FIG. 11B is a graph showing sort machine utilization comparison of as-is and scenario 1, in accordance with some embodiments of the present disclosure.
FIG. 11C is a graph showing sort machine throughput comparison of as-is and scenario 1, in accordance with some embodiments of the present disclosure.
FIG. 11D is a graph showing on-time delivery comparison of as-is and scenario 1, in accordance with some embodiments of the present disclosure.

### DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

The terms or expressions such as 'network', 'parcel delivery network', 'distribution network' are used interchangeably based on the context and the application of the present disclosure, otherwise such terms or expressions refer to chain of networks of a given company defined for their operations and services.

Increasing connectedness of the world is leading to growing demand for efficient supply chain companies such as postal delivery companies. As a result, the parcel delivery industry valued at USD 486.47 Billion in 2023 is projected to expand at a 4.2% CAGR to reach USD 648.84 Billion by 2030 as forecasted by Steller Market Research 2024. However, as this growth comes with intensifying competition, the parcel delivery companies are experiencing a rapid narrowing of profit margins while customer expectations for flawless and punctual deliveries continue to rise (Orenstein and Raviv 2022). The uncompromisable commitment to delivering parcels promptly across vast geographic expanses compounded with the need for increasingly shorter delivery windows through efficient operations using optimal resources poses a significant challenge for these companies.

Establishing a delicate balance between meeting customer demands and ensuring profitability in the face of the micro and macro uncertainties of the domain is paramount for the postal delivery companies. At the micro level, the parcel delivery companies grapple with challenges such as fluctuating parcel volumes, dynamic resource availability across facilities, and unforeseen disruptions within the network. Concurrently, they must navigate macro-level uncertainties, including evolving consumer preferences and shifting market trends in terms of new services and business models. As a result, adaptation and resilience emerge as two key properties of large parcel delivery companies for effectively managing complexity and uncertainty.

Adaptation, in this context, refers to the ability of the network to adjust its strategies, operations, infrastructure and resources in response to changing environmental conditions such as fluctuating parcel volumes, evolving customer preferences, and unforeseen disruptions. It involves proactive decision-making for necessary changes to better network performance, enhance efficiency, improve service level commitments, and provide better services. Resilience, on the other hand, pertains to the network's ability to recover from disruptions or disturbances while maintaining its essential functions and services. Resilience involves building robustness into the network's structure and operations to minimize the impact of disruptions and enable swift recovery when disruptions occur. It expects continuous sensing and reactive changes to bounce back from disruptions and continue functioning effectively despite challenges.

Balancing adaptability and resilience within parcel delivery networks requires consistent focus on two crucial loops: a resilience loop for sensing and recovering from undesired network states by adjusting the existing network, and an adaptation loop for foreseeing and extending the capacity or capability of the network to avoid undesired future conditions. While the resilience loop emphasizes network robustness, the adaptation loop demands extensibility and flexibility. However, achieving this equilibrium is complicated for large parcel delivery networks due to factors such as network size, heterogeneity in terms of nodes (i.e., facilities) and edges (paths connected through fleets), dynamism of the operating environment, and inherent uncertainty. Several trade-offs arise such as: enhancing the capacity of individual nodes versus extending topology of the network, investing in redundant resources for resilience versus optimizing resource utilization for adaptability, and prioritizing short-term efficiency versus long-term adaptability and resilience.

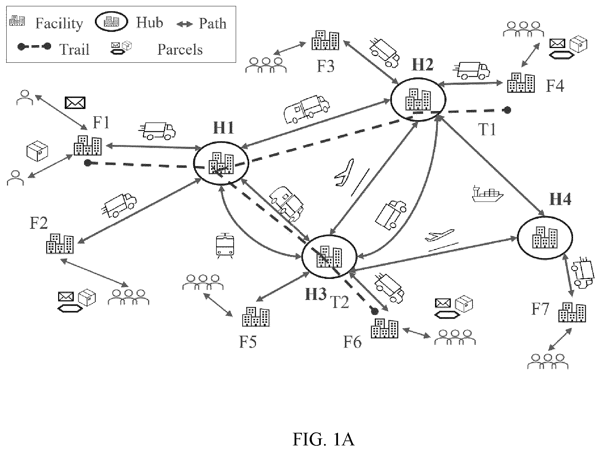

The Parcel Delivery Network (PDN), comprising strategically positioned facilities like collection centers, distribution centers, sorting terminals, and hubs, interconnected along predefined paths. FIG. 1A shows an exemplary physical model of a conventional parcel delivery network. As shown in FIG. 1A, the parcels are collected from designated facilities, moved along interconnected paths via various fleets such as trucks, tractors, rail, flights, and ships, and finally delivered to their intended destinations. Conceptually, the PDN is represented as a network with nodes representing facilities (F), and edges representing paths (P) connecting these facilities. Each facility is a unique self-organizing autonomous unit, while the paths have specific modalities like road, air, or water, along with distinct characteristics such as distance and geographical traits. Additionally, the PDN includes fleets or vehicles (V) that traverse dedicated paths, known as trails (T), making PDN a directed and temporal network. The facilities within the PDN are complex units responsible for various activities such as parcel collection, sorting based on parcel characteristics and destinations, and onward delivery by loading sorted parcels onto fleets or containers.

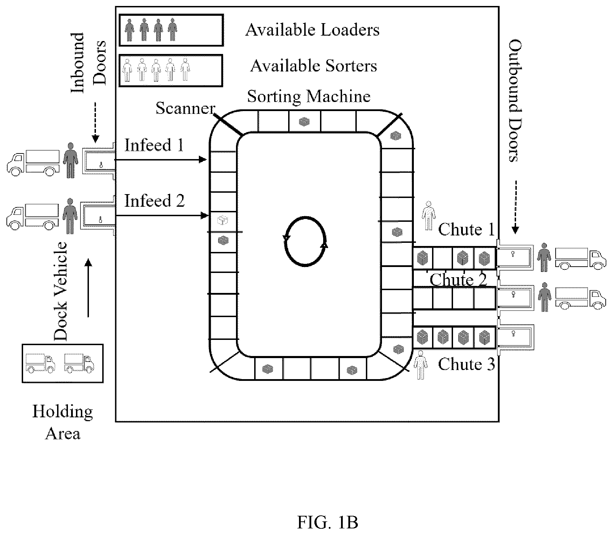

FIG. 1B shows an exemplary visual representation of a typical facility (F) of the physical model of the conventional parcel delivery network as shown in FIG. 1A. As shown in FIG. 1B, these facilities have a layout with holding areas, infeeds, scanners, sorting machine, and chutes to manage parcel movements efficiently. Facilities have autonomy to dynamically control operational factors, such as resource allocation including loaders and sorters, sorting machine configuration, and engaging and allocating chutes for specific destinations to optimize key performance indicators (KPIs) including parcel throughput, dwell time within the facility.

Thus, the distribution network structure focuses on defining and extending the network and its elements, such as facilities and fleets. Their explorations, which are pertinent, include factors like the number of facilities needed for a distributed network, their optimal locations, demand allocation, and capacity planning. The supply chain literature also delves into echelon definition to align the network structure with different phases of the supply chain, but this aspect is less relevant to the present disclosure. In contrast, operational policies and decision-making activities include configuring established networks and facilities. Their key exploration areas are transport routing design, path planning, fleet allocation and planning, fleet loading and packing, and resource allocations. Additionally, they extensively explore inventory-related aspects such as replenishment and optimum inventory levels, which are less relevant to the present research focus. In terms of modeling and analysis techniques, the literature predominantly leans towards mixed-integer programming models (Vidal and Goetschalckx 1997) with various algorithmic formulations, including linear or non-linear and single or multi-objective functions. Other mathematical approaches, such as Ant Colony Optimization (Barcos et al. 2010) and fuzzy goal programming (Selim et al. 2008), are also explored.

The overall performance of the PDN, measured through KPIs like rate of on-time parcel delivery, average delay time, parcel transit time, fleet utilization, and average of facility-specific KPIs, relies heavily on the capacity of facilities, existing paths and their characteristics, trail definitions, and number of fleets and their characteristics. Here, adaptability in a PDN is achieved by adding new facilities (F), paths (P), or fleet (V) types, while resilience is enhanced by rebalancing network by redefining trails, resource adjustments, and reconfigurations of facility related parameters.

Adaptations and resilience for facilities can include introducing or changing sorting schedules, destination chute assignment, resource assignments, and infrastructure reconfigurations like recirculation count. However, deciding effective changes for facility and network level adaptation and resilience presents significant challenges due to the large number of heterogeneous facilities, frequent change of parcel volumes, uncertainties along fleet availability, disruption in the path and resource availability, and various other factors.

Conceptually, the PDNs can be formed by categorizing facilities into collection centers (C) and distribution centers (D) and connecting them as a bipartite graph. While this setup can ensure timely parcel delivery, it is not a logistically and economically viable option for a parcel delivery company who is aiming to deliver a high volume of parcels across multiple destinations. A conventional regular network where facilities are connected only with their neighbor facilities results in long characteristic path lengths, leading to potential delays and operational losses. These networks also lack resilience, making them vulnerable to disruptions in facilities or paths. Adding paths between frequently connected facilities as suggested by the Watts-Strogatz (WS) model (Watts and Strogatz 1998) improves adaptability but struggles with sudden parcel influxes, impacting resilience negatively. A scale-free network (Barabási and Bonabeau 2003) with a Core-Periphery (CP) structure (Borgatti and Everett 2000), conforming to the power law and small-world properties of network theory, enhances resilience but may underutilize some hubs, necessitating cost optimization. Similarly, a dense core enhances adaptability but risks fleet underutilization.

For practical reasons, geographically central facilities with multiple transportation options gain strategic importance. Exemplifying the rich-get-richer principle in network theory, they form dense clusters with high local clustering coefficient and multiple triadic relationships. However, multiple such clusters with low inter-cluster connectivity elevate the betweenness property of specific facilities in H (bridge facilities between clusters as shown in FIG. 1B), potentially reducing network resilience and causing bottlenecks. Therefore, striking a balance between making the core of a PDN optimal for desired resilience and adaptability without compromising utilization is crucial. The key lies in balancing and rebalancing the core topology by meticulously evaluating the capability and elasticity of core facilities (H) alongside the parcel load of the entire network, including the periphery, to ensure resilience. Likewise, predictions about future parcel loads and potential disturbances across the network must be intricately correlated with different core properties to establish PDN adaptability.

Currently, companies take decisions by focusing on localized context, such as operation within the facility, fleet management for a specific type of vehicle, and path planning for expected parcel volume. They consider a wide range of optimization techniques such as bin packing approach, routing algorithms, and so on. However, these locally optimal solutions fail to ensure global robustness and flexibility for the entire network. Moreover, such solutions often fail to scale for the desired number of parcels and typically are not cognizant of the inherent heterogeneity and uncertainty. More advanced AI-powered data-centric approaches produce ineffective solutions when: (i) the available data is limited, (ii) the context is dynamic (thus posing a challenge on relevancy of data), and (iii) faced with unforeseen scenarios.

Drawing inspiration from the emerging field of digital twins (Grieves and Vickers 2017), wherein virtual replicas of physical systems are created to simulate behaviors in a virtual environment of the companies and their managing networks (herein after referred as physical networks or physical models). Thus, the present disclosure makes the physical model of the network in the virtual environment for carrying out various things required in future.

Simulation is considered in limited contexts (Chan 2006; Barat et al. 2022), chiefly for predicting the impacts of specific interventions on distribution performance for localized context. From an analysis objective perspective, the literature prominently focuses on single objective functions. The exploration of multiple objective functions is less explored. There are limited instances of multi-objective models that primarily consider cost as one factor and different service level criteria like timely delivery as another for tradeoff. These models aim to identify the best trade-offs between objectives. For example, Melachrinoudis et al. (2005) proposed a multiple criteria optimization model for minimizing annual operating costs while maximizing customer service. Similarly, Sabri and Beamon (2000) developed a multi-objective model to solve the supply chain planning problem, taking into consideration cost minimization, fill rate maximization, and the maximization of delivery flexibility.

The key limitations of these approaches are manifold. Firstly, many techniques focus on limited contexts, such as individual facilities or fleet management, for context-specific local optimization without considering network-level global factors. Secondly, most of the mathematical approaches are not cognizant of the associated heterogeneities of the elements, such as a wide range of parcel characteristics and fleet types, and the inherent uncertainties of PDN. Lastly, most analyses rarely consider more than two objective functions and trade-offs, and they struggle to scale beyond certain levels, necessitating the use of approximation techniques. Grossly approximated approaches fail to produce effective solutions for large and complex PDNs.

The present disclosure solves the technical problems in the art with the methods and systems for constructing and simulating a digital twin of physical model of the supply chain companies such as the PDNs. The methods and systems of the present disclosure advocates for a paradigm shift from focusing on localized contexts to the entire parcel network to impart adaptiveness and resilience. At the heart of this holistic approach is the concept of a composite digital twin (Kuruppuarachchi et al. 2022), where digital twin of the physical model (or distribution network) is a composition of constituent digital twins each catering to facilities, fleets, resources and so on.

The present disclosure employs an extended form of agent / actor formalism to implement constituent digital twins. Each of these digital twins is a set of autonomous interacting agents responding to their events of interest and taking suitable actions aimed at achieving their individual goals. The extended form of agent / actor formalism is employed by the present disclosure to implement digital twin of the physical model (i.e., composite digital twin) as a set of autonomous interacting agents where each of these agents represents the corresponding constituent digital twin. For the sake of clarity, these agents are referred to as composite agents. The simulatable nature of the digital twin of the present disclosure facilitates in-silico experiments at various levels, ensuring both local and global properties. This empowers stakeholders to understand the bottlenecks within the existing network, explore alternative future scenarios, devise strategies to reduce bottlenecks, and prevent undesired future situations.

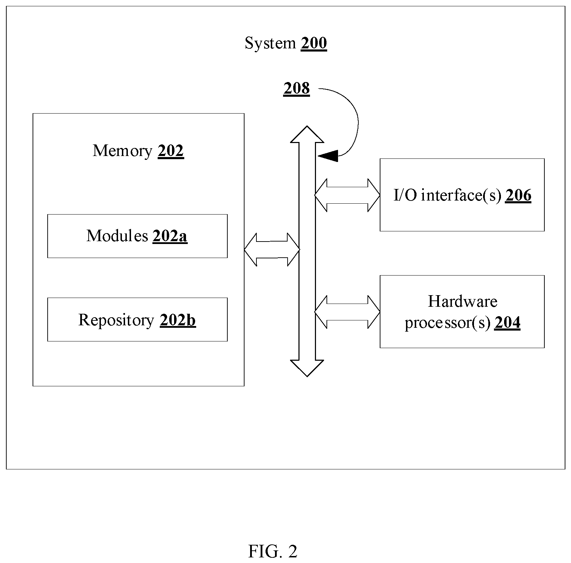

Referring now to the drawings, and more particularly to FIG. 2 through FIG. 11D, where similar reference characters denote corresponding features consistently throughout the figures, there are shown preferred embodiments, and these embodiments are described in the context of the following exemplary systems and/or methods.

FIG. 2 is an exemplary block diagram of a system 200 for constructing and simulating a digital twin of physical model, in accordance with some embodiments of the present disclosure. In an embodiment, the system 200 includes or is otherwise in communication with one or more hardware processors 204, communication interface device(s) or input/output (I/O) interface(s) 206, and one or more data storage devices or memory 202 operatively coupled to the one or more hardware processors 204. The one or more hardware processors 204, the memory 202, and the I/O interface(s) 206 may be coupled to a system bus 208 or a similar mechanism.

The I/O interface(s) 206 may include a variety of software and hardware interfaces, for example, a web interface, a graphical user interface, and the like. The I/O interface(s) 206 may include a variety of software and hardware interfaces, for example, interfaces for peripheral device(s), such as a keyboard, a mouse, an external memory, a plurality of sensor devices, a printer and the like. Further, the I/O interface(s) 206 may enable the system 200 to communicate with other devices, such as web servers and external databases.

The I/O interface(s) 206 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface(s) 206 may include one or more ports for connecting a number of computing systems with one another or to another server computer. Further, the I/O interface(s) 206 may include one or more ports for connecting a number of devices to one another or to another server.

The one or more hardware processors 204 may be implemented as one or more microprocessors, microcomputers, microcontrollers, digital signal processors, central processing units, state machines, logic circuitries, and/or any devices that manipulate signals based on operational instructions. Among other capabilities, the one or more hardware processors 204 are configured to fetch and execute computer-readable instructions stored in the memory 202. In the context of the present disclosure, the expressions 'processors' and 'hardware processors' may be used interchangeably. In an embodiment, the system 200 can be implemented in a variety of computing systems, such as laptop computers, portable computers, notebooks, hand-held devices, workstations, mainframe computers, servers, a network cloud and the like.

The memory 202 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. In an embodiment, the memory 202 includes a plurality of modules 202a and a repository 202b for storing data processed, received, and generated by one or more of the plurality of modules 202a. The plurality of modules 202a may include routines, programs, objects, components, data structures, and so on, which perform particular tasks or implement particular abstract data types.

The plurality of modules 202a may include programs or computer-readable instructions or coded instructions that supplement applications or functions performed by the system 200. The plurality of modules 202a may also be used as, signal processor(s), state machine(s), logic circuitries, and/or any other device or component that manipulates signals based on operational instructions. Further, the plurality of modules 202a can be used by hardware, by computer-readable instructions executed by the one or more hardware processors 204, or by a combination thereof. In an embodiment, the plurality of modules 202a can include various sub-modules (not shown in FIG. 2). Further, the memory 202 may include information pertaining to input(s)/output(s) of each step performed by the processor(s) 204 of the system 200 and methods of the present disclosure.

The repository 202b may include a database or a data engine. Further, the repository 202b amongst other things, may serve as a database or includes a plurality of databases for storing the data that is processed, received, or generated as a result of the execution of the plurality of modules 202a. Although the repository 202b is shown internal to the system 200, it will be noted that, in alternate embodiments, the repository 202b can also be implemented external to the system 200, where the repository 202b may be stored within an external database (not shown in FIG. 2) communicatively coupled to the system 200. The data contained within such external database may be periodically updated. For example, data may be added into the external database and/or existing data may be modified and/or non-useful data may be deleted from the external database. In one example, the data may be stored in an external system, such as a Lightweight Directory Access Protocol (LDAP) directory and a Relational Database Management System (RDBMS). In another embodiment, the data stored in the repository 202b may be distributed between the system 200 and the external database.

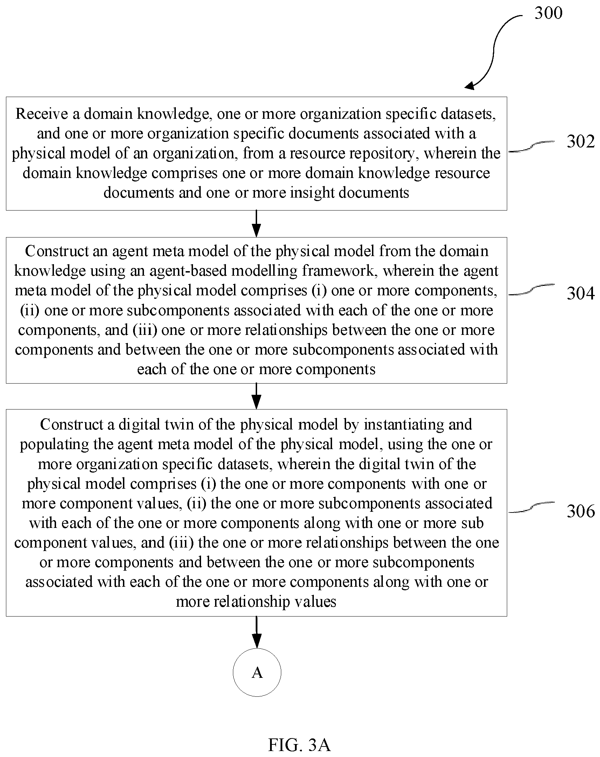

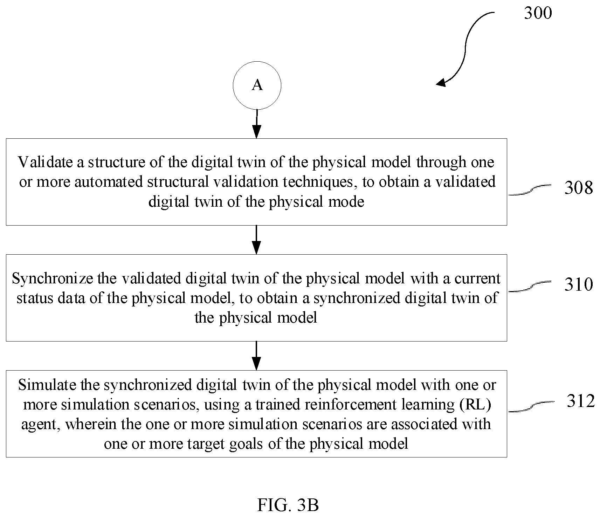

Referring to FIGS. 3A and 3B, components and functionalities of the system 200 are described in accordance with an example embodiment of the present disclosure. For example, FIGS. 3A and 3B illustrate exemplary flow diagrams of a processor-implemented method 300 for constructing and simulating a digital twin of physical model, using the system 200 of FIG. 2, in accordance with some embodiments of the present disclosure.

Although the steps of the method 300 shown in FIGS. 3A and 3B including process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any practical order. Further, some steps may be performed simultaneously, or some steps may be performed alone or independently.

At step 302 of the method 300, the one or more hardware processors 204 of the system 200 are configured to receive a domain knowledge, one or more company specific datasets, and one or more company specific documents associated with a physical model of a company. The domain knowledge domain knowledge includes one or more domain knowledge resource documents and one or more insight documents. In an embodiment, the physical model refers to core structure or the architecture of the given company. For example, the physical model is a parcel delivery network (PDN) in the case of parcel delivery companies.

In an embodiment, the one or more domain knowledge resource documents are the documents or data sources that are associated with the physical model of the company and made by the domain experts or by others that have the prior knowledge about the physical model. In an embodiment, one or more insight documents are the documents or data sources that provide the insights about the physical model of the company. The one or more company specific datasets are related to various assets (for example, conveyor belt of the PDN, facilities, and so on) that are part of the physical model. The domain knowledge, the one or more company specific datasets, and the one or more company specific documents are stored in a resource repository. The domain knowledge, the one or more company specific datasets, and the one or more company specific documents are utilized to construct the digital twin (virtual model) that resembles the physical model of the company.

At step 304 of the method 300, the one or more hardware processors 204 of the system 200 are configured to construct an agent meta model of the physical model using an agent-based modelling framework. The domain knowledge received at step 302 of the method 300 is used to construct the agent meta model using the agent-based modelling framework.

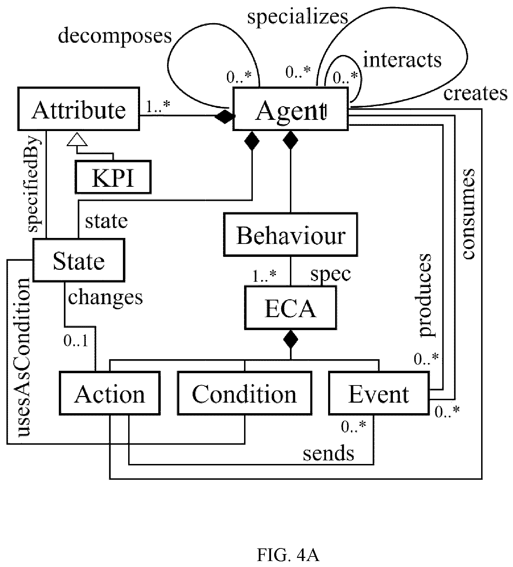

FIG. 4A shows an exemplary agent metamodel in accordance with some embodiments of the present disclosure. As shown in FIG. 4A, the exemplary agent metamodel is an extended form of agent abstraction. The extended agent can hierarchically compose multiple agents or decompose into fine-grained agents at any level to sufficiently represent elements of complex systems, including those exhibiting the system-of-systems notion. An agent can be specialized to represent different types of elements capturing their heterogeneity and variations, such as facilities with different configurations and capacities, types of fleets, and types of parcels and services. These agents interact with each other through sending and receiving events.

For example, a fleet in PDN can notify its arrival event to the facility where it has arrived, or a facility can send an event to its loaders for parcel pickup. Internally, an agent encapsulates a set of attributes, its state, and behavior, where the value space of the attributes defines the state. The behavior of an agent is defined using a set of ECA specifications: If an event occurs and a condition on the state space is satisfied, then perform an action. An action can change the state space of the agent, send events to its own or other agents, create new agents, or perform a combination of these possible types of actions.

The agent probabilistic is made by associating probability values with the action specification, i.e., perform action a1 with probability x1, a2 with probability x2, and so on. Further, the agent specification temporal is made by considering internal or external events explicit to the agent, for example, the end of a day or hour. In this, certain attributes of the agent can represent KPIs of the elements, such as KPIs of facilities, fleets, and the PDN. This enhanced notion of agent abstraction allows us to capture the intricacies of the constituent elements of the PDC and its environment. The stochastic behavioral specification is one of the crucial aspects for capturing the inherent uncertainties and randomness of PDN elements, while temporal behavior allows to model time-dependent activities, such as parcel delivery times or facility processing rates.

The agent meta model of the physical model in general includes (i) one or more components (alternatively referred as agents), (ii) one or more subcomponents associated with each of the one or more components, and (iii) one or more relationships (alternatively referred as interactions) between the one or more components and between the one or more subcomponents associated with each of the one or more components. For example, in the case of the PDN, the one or more components are facilities, fleets and operations.

The facilities encompass the physical locations that are critical to the delivery operations. For instance, supply chain serves as central points where packages are temporarily held before dispatch. Examples include regional distribution centers that manage inventory. Another important part of facilities is Loading Bays, where packages are loaded into delivery vehicles-like a designated bay specifically for trucks at a distribution center. The role of Dispatch Centers is to manage outgoing flow, ensuring timely deliveries. Further, Conveyor Belts like automated sorting systems streamline package handling, while Docking Stations facilitate the efficient loading and unloading of cargo.

The fleet consists of the vehicles that transport goods. Delivery Trucks, for example, are preferred for bulk deliveries, while Vans are typically allocated for smaller routes. Motorcycles offer agility for swift deliveries, especially in congested urban settings. The innovative use of Airplanes adds a modern dimension, enabling aerial transport. Lastly, Maintenance Vehicles ensure the fleet remains operational, preventing downtime.

The operations are the lifeblood of the network, encompassing various processes that manage goods' movement. This involves sorting processes that categorize packages by destination, as well as Load Planning strategies that optimize how goods are loaded into vehicles. Furthermore, Route Optimization techniques are employed to find the most efficient routes, decreasing delivery time and enhancing customer satisfaction.

For example, in the case of the PDN, each of the one or more components include subcomponents. For example, sub-facilities in the case of facilities, sub-fleets in the case of fleets, and so on. Similarly, the one or more relationships between the one or more components refer to the relationships between two given components. For example, relationships between two given facilities, similarly the one or more relationships between the one or more subcomponents associated with each of the one or more components.

A parcel delivery company (PDC) or the organization can be effectively represented (PDCM) using three fundamental components or the entities: Environment (E), PDN, and parcels/shipments (S), i.e., PDCM is tuple < E, PDN, S >. The environment entity (E), which mimics the PDC's environment, is responsible for sending parcels and shipments (S) with distinct characteristics such as weight, size, shape, destination, and delivery service options like normal, priority, or 1-day delivery to the PDC. The PDN orchestrates the delivery process, which further can be defined using three elements: Facilities (F), Paths (P), and Fleets (V), i.e., a tuple <F, P, V >. Facilities and fleets are dynamic and autonomous entities, while paths, connected through the movement of fleets, act as directed links between two facilities, represented as p =< fi, f j,vk > where fi, f j ∈ F, vk ∈ V. In this topology, facilities with multiple incoming paths and at least one outgoing path represent Hubs (H).

The set of hub facilities H form the core of the PDN. Facilities with no incoming paths are typically termed as Collection centers (C), and facilities having no outgoing paths serve as destination centers (D). Facilities with fewer incoming and outgoing paths, including those from C and D, form the periphery of the PDN. It's important to note that any facility, irrespective of whether it belongs to C, D, or H, may receive parcels from E and dispatch parcels to E. Facilities from C and D exhibit specialized behavior compared to other facilities, while facilities from H also exhibit specialized behaviors to route a high volume of shipments to a large number of destinations. In addition to these topological concepts, the PDC uses the concept of a Trail (T), where each trail represents a sequence of paths. These trail definitions help orchestrate parcels and shipments (S) through the PDN.

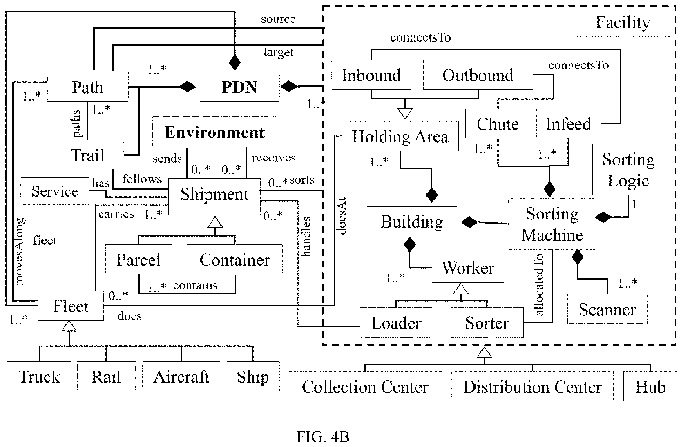

A composable, parameterized, and simulatable agent abstraction is employed in the present disclosure to represent PDCM, which includes the environment, PDN, and various types of parcels and shipments (S). FIG. 4B shows a schematic view of an exemplary agent topology of the PDN in accordance with some embodiments of the present disclosure. The Environment is an agent that acts as a parcel and shipment feeder to the PDN. Each Parcel is represented using the agent whose attributes capture the heterogeneous characteristics of the parcel, such as weight, size, shape, and delivery service, along with its source and destination facilities. The shipment is considered as a composite agent that contains multiple parcel agents with the same destination. In this formation, environment agents can produce heterogeneous parcel and shipment agents in a specific order and interval either by conforming to parcel flows of the real system or by depicting future or disrupted scenarios. For example, potential fluctuations in daily parcel flows, different parcel mix, different combination of parcel destinations and their arrival sequences can be introduced into the PDN for experimentations.

The PDN agent is a composite agent that contains facility agents and fleet agents through composition relations. It also captures paths and trails as attributes of the PDN agent (as they are not active elements). A path is captured as a list type attribute, and a trail is represented using a table structure. We make these compositions and attributes configurable through parameterization to introduce and remove paths and facilities to the PDN and define/redefine trails (conforming to path definition) to adjust and configure parcel orchestrations. Here, the behavior of the PDN is not explicitly specified; rather, it emerges from the behaviors of its constituent elements.

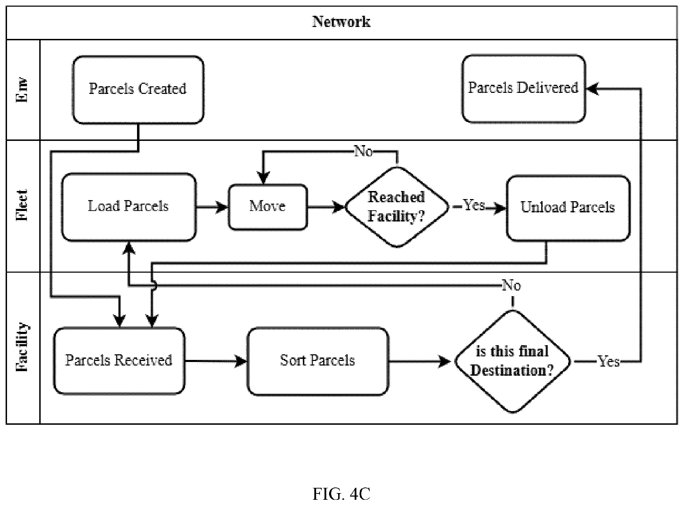

FIG. 4C shows exemplary agent interactions between the agents of the PDN in accordance with some embodiments of the present disclosure. The key interactions between the Environment and PDC, along with the interactions between facility and fleet agents within the PDC are shown in FIG. 4C. Essentially, as depicted in the FIG. 4C, shipment agents originating from the environment agent move from one agent to another while navigating involved facilities and fleets of respective trails, which originate from the source facility and lead to their intended destination facility. In these transitions, container agents, such as fleets and facilities (along with their constituent agents), manages where and when these shipments will move to the next destination, how they will be sorted, and how much time they will take for sorting, etc. As depicted in FIG. 4B, a facility is another composite agent that composes a set of agents representing its structural elements, such as inbound and outbound holding areas, constituent machines and assets like sorting machines, and different types of workers including loaders and sorters. The constituent agent representing the sorting machine is also a composite agent that contains agents representing its parts including infeeds, chutes, and scanners. The sorting machine also contains passive and configurable elements, such as sorting logic. The sorting logic orchestrates the parcel sorting by assigning destination chute of a parcel, which conforms to its trail definition.

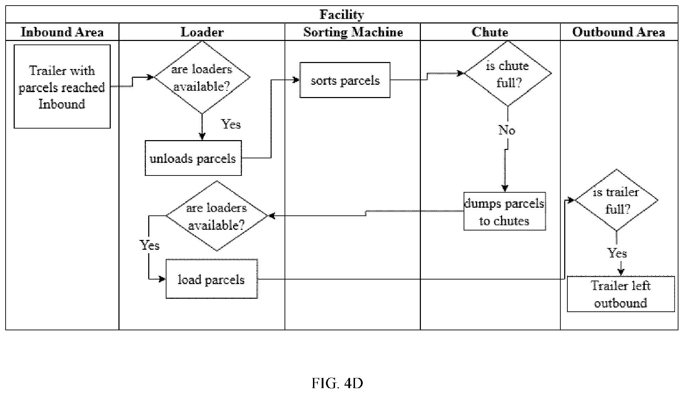

FIG. 4D shows exemplary agent interactions of the facility agent of the PDN in accordance with some embodiments of the present disclosure. As shown in FIG. 4D, the agent behaviour for orchestrating shipment movements within the facility. Like the facility agent, Fleet is another active element in PDN, which is represented using a composite agent. It moves along the paths and can dynamically contain parcels that come in and go out based on their trail-definitions. Different modes of fleets can be described as truck, rail, air and ship. The further specializations are possible to introduce specific type of the vehicle, such as small, medium and large trucks.

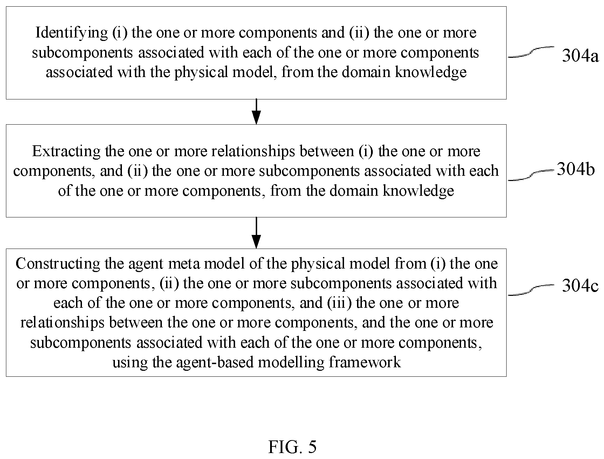

FIG. 5 is a flow diagram showing steps for constructing the agent meta model of the physical model from the domain knowledge using an agent-based modelling framework, in accordance with some embodiments of the present disclosure. As shown in FIG. 5, constructing the agent meta model of the physical model from the domain knowledge using the agent-based modelling framework is explained through steps 304a to 304c.

At step 304a, the one or more components and the one or more subcomponents associated with each of the one or more components associated with the physical model, are identified from the domain knowledge. At step 304b, the one or more relationships (the interactions) between the one or more components, and the one or more subcomponents associated with each of the one or more components, are extracted from the domain knowledge.

Then, at step 304c, the agent meta model of the physical model is constructed using the one or more components and the one or more subcomponents associated with each of the one or more components identified at step 304a, and the one or more relationships between the one or more components, and the one or more subcomponents associated with each of the one or more components extracted at step 304b, using the agent-based modelling framework.

At step 306 of the method 300, the one or more hardware processors 204 of the system 200 are configured to construct a digital twin of the physical model. The digital twin of the physical model is constructed by instantiating and populating the agent meta model of the physical model constructed at step 304 of the method 300, using the one or more company specific datasets received at step 302 of the method 300. The digital twin is a virtual model and exact replica in digital form of the digital twin of the physical model with actual values.

Thus, the digital twin of the physical model includes (i) the one or more components with one or more component values, (ii) the one or more subcomponents associated with each of the one or more components along with one or more sub component values, and (iii) the one or more relationships between the one or more components and between the one or more subcomponents associated with each of the one or more components along with the one or more relationship values.

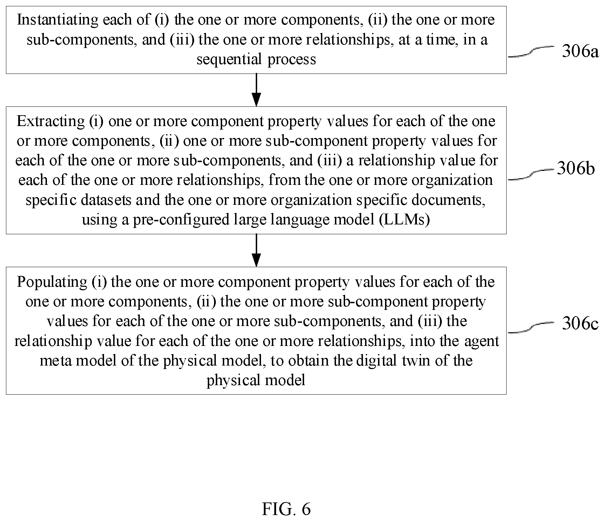

FIG. 6 is a flow diagram showing steps for constructing the digital twin of the physical model by instantiating and populating the agent meta model of the physical model, in accordance with some embodiments of the present disclosure. As shown in FIG. 6, constructing the digital twin of the physical model by instantiating and populating the agent meta model is explained through steps 306a to 306c. At step 306a, each of (i) the one or more components, (ii) the one or more sub-components, and (iii) the one or more relationships between the one or more components and between the one or more subcomponents associated with each of the one or more components, are instantiated at a time, in a sequential process.

At step 306b, (i) one or more component property values for each of the one or more components, (ii) one or more sub-component property values for each of the one or more sub-components, and (iii) a relationship value for each of the one or more relationships, are extracted from the one or more company specific datasets and the one or more company specific documents, using a pre-configured large language model (LLMs). In an embodiment, an application programming interface (API) is developed for the relational database interaction to extract the one or more component property values the one or more sub-component property values and the relationship values from the one or more company specific datasets and the one or more company specific documents. Furthermore, the pre-configured large language model (LLMs) is employed to automate the extraction of insights from unstructured documents. Extraction of necessary information from unstructured data by taking input as unstructured documents, the agent metamodel and predefined template prompts by dynamic prompt generation based on missing data from metamodel and executing the prompt to extract relevant data.

For example, for the facilities component comprising warehouses, loading bays, and operational metrics, the values are extracted as follows:
a. Warehouses: a query is initiated to the Facility Management Database to pull detailed records of Warehouses. The attributes such as capacity, location, operating hours, and inventory levels are specifically identified. The output here directly populates the agent metamodel with precise facility characteristics.
b. Loading Bays: Next, loading bay configurations including dimensions, current occupancy, and operational status are extracted. This involves querying the same database but focusing on a different set of fields that pertain to loading capabilities.
c. Operational Metrics: For facilities like conveyor belts, the data concerning performance parameters such as speed, maintenance schedule and downtime are fetched through automated reports generated by the facility management software.

For example, for the fleet component, the values concerning the operational capacities of the vehicles are extracted as follows:
a. Delivery Trucks and Vans: the Vehicle Management Database is queries for specifications-make, model, age, and maintenance history. This data ensures that the metamodel of the present disclosure reflects not just the physical vehicles but also their operational readiness.
b. Daily Usage Statistics: The fleet logs are analyzed to extract real-time usage statistics such as miles driven, fuel consumption, and load capacities. This information can be obtained through daily operational reports generated by fleet management software.

For example, for the operations component, the values are extracted as follows:
a. Sorting Processes: The documents are extracted from the central operational database that outlines the sorting methodology. Patterns of package movement during peak operations provide the metrics for the metamodel.
b. Load Plans: The past load planning documents and current load configurations are accessed through operational databases to understand how packages are strategically organized for delivery. This data helps inform the metamodel about operational efficiency.
c. Route Codes: The routing data is analyzed using a routing software to understand historical routing efficiency. This analysis involves fetching route details and assessing average delivery times over specific periods.

At step 306c, (i) the one or more component property values for each of the one or more components, (ii) the one or more sub-component property values for each of the one or more sub-components, and (iii) the relationship value for each of the one or more relationships, are populated into the agent meta model of the physical model constructed at step 304 of the method 300, to obtain the digital twin of the physical model.

By leveraging a systematic approach to fetch data from various databases and employing advanced techniques to handle both structured and unstructured information, the agent metamodel for the PDN is accurately populated with real-world data. This robust dataset sets the groundwork for the next steps, including structural validation and synchronization, ultimately creating the digital twin that closely resembles operational reality. Thus, the digital twin is the agent metamodel of the physical model populated with the real-time data.

At step 308 of the method 300, the one or more hardware processors 204 of the system 200 are configured to validate a structure of the digital twin of the physical model through one or more automated structural validation techniques, to obtain a validated digital twin of the physical model.

With the agent metamodel populated with real-time data, the next crucial step is structural validation. This process ensures that the digital twin accurately mirrors the physical model and confirms that all components and their interconnections are coherent, consistent, and operationally viable.

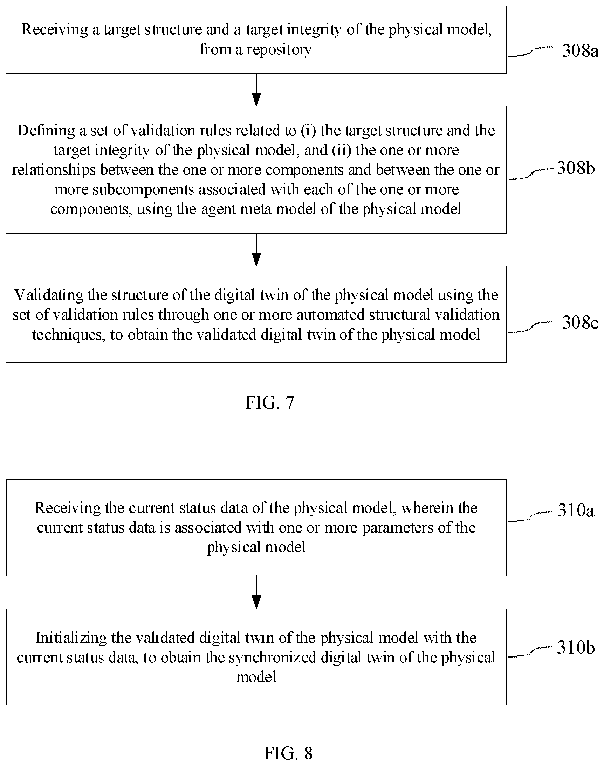

FIG. 7 is a flow diagram showing steps for validating the structure of the digital twin of the physical model through one or more automated structural validation techniques, in accordance with some embodiments of the present disclosure. As shown in FIG. 7, validating the structure of the digital twin of the physical model is explained through steps 308a to 308c.

At step 308a, a target structure and a target integrity of the physical model, are received from a repository. At step 308b, a set of validation rules related to (i) the target structure and the target integrity of the physical model, and (ii) the one or more relationships between the one or more components and between the one or more subcomponents associated with each of the one or more components, are defined by a user using the agent meta model of the physical model. The set of validation rules reflect the expected structure, integrity, and relationships between the components and subcomponents. An execution engine is employed to process these set of validation rules

Then, at step 308c, the structure of the digital twin of the physical model is validated using the set of validation rules through one or more automated structural validation techniques, to obtain the validated digital twin of the physical model. The one or more automated structural validation techniques ensure that the validation (done using component integrity rule) such as hierarchy validation, cross referencing, data completeness validation, topology and layout validation are performed. Further, inconsistency/error are checked, and appropriate corrections are done using anyone option from the available two options of manual and automatic correction. The validation process is performed after the correction until no errors are found.

Establishing Validation Criteria: The first step in structural validation is to define clear criteria against which the metamodel will be assessed. This criterion includes:
a. Data Completeness: Ensuring that all necessary components are represented and filled with relevant data. For instance, checking that all Warehouses and fleet details have corresponding entries in the metamodel.
b. Data Consistency: Verifying that the data does not have conflicting information. For example, if one dataset indicates conveyor belt information, no other dataset should contradict that.
c. Component Interrelationships: Analyzing whether the relationships among components, such as how Warehouses interact with the fleet, are accurately represented. This involves ensuring that all facilities linked to a particular delivery route are correctly mapped.

Automated Validation Processes: To streamline the validation process, several automated scripts are generated for the systems to check the integrity of the metamodel:
a. Data Integrity Checks: Automated scripts that run integrity checks on the data are implemented. For instance: Scripts perform null value checks to make sure no component is missing essential data. If a storage hub does not have a location or capacity defined, the script flags this for review.
b. Data type validation is also conducted, ensuring that fields like vehicle IDs or inventory counts adhere to the expected formats.

Consistency Checks: Next, the checks are automated to ensure data consistency. For example, the comparisons between various datasets are automated to identify discrepancies, such as different metrics for the same delivery truck across databases. When an inconsistency is detected, corresponding alerts are generated for the concerned team to investigate further.

Interrelationship Mapping: To analyze component interrelationships visualization tools are generated. For example, using graph-based visualization libraries, diagrams are created that illustrate how different components are connected. This makes it easier to spot any potential disconnections or errors in the relationships. If a particular facility does not have any linked delivery routes or vehicles, it can be visually identified for further investigation.

Three-step structural validation process ensures that the agent metamodel is a reliable reflection of the actual delivery network. Through a blend of automated checks, manual expertise, and advanced AI techniques, integrity, consistency, and interrelationships are validated. This step is crucial for ensuring that the digital twin is not only accurate but also operationally functional, serving as a decisive tool for simulation, optimization, and informed decision-making.

At step 310 of the method 300, the one or more hardware processors 204 of the system 200 are configured to synchronize the validated digital twin of the physical model with a current status data of an actual physical model, to obtain a synchronized digital twin of the physical model. Once the structural validation is complete, the next critical step is synchronization. This step ensures that the digital twin is initialized to align with the current state of the actual physical model.

FIG. 8 is a flow diagram showing steps for synchronizing the validated digital twin of the physical model, in accordance with some embodiments of the present disclosure. As shown in FIG. 8, validating the structure of the digital twin of the physical model is explained through steps 310a to 310b. At step 310a, the current status data of the actual physical model is received. The actual physical model is the real model, for example the real PDN. The current status data is associated with one or more parameters of the physical model. The one or more parameters includes the parameters of the physical model which can be sensed using internet-of-things (IoT) sensors. At step 310b, the validated digital twin of the physical model constructed at step 308 of the method 300 is initialized with the current status data, to obtain the synchronized digital twin of the physical model. The synchronized digital twin of the physical model can be used for analyzing the actual physical model through the simulation.

Thus, the synchronizing the validated digital twin of the physical model is performed by taking input from data IoT sensors and current state data. For example, the input data from Internet of things sensors associated with PDN may include parameters such as chute blockage, package counts, and conveyor belt status to reflect the current state of the PDN. The current state can be defined as a real time situation of the PDN.

In an embodiment, the synchronization is performed as follows:
Data Capture: To initialize the digital twin, the relevant data is captured from the physical model (system) using IoT devices and sensors deployed across various facilities and within the fleet:
a. IoT Sensors: These sensors collect parameters such as Chute blockage, package counts, and conveyor belt status to reflect the system's current state.
b. GPS Tracking: Delivery vehicles provide location data and status updates of the vehicles, through GPS units.

Data Integration: A message queuing system such as Apache Kafka is employed to manage the initial influx of data. Each IoT device publishes its data to designated Kafka topics, allowing the digital twin to absorb and synchronize this data during initialization. Automated services parse and process the incoming data, ensuring that the digital twin mirrors the current state of the physical model accurately.

Update Mechanisms: For the initial synchronization, updates to the digital twin occur as data is verified and integrated. New data entries are checked against the model's predefined structures. Updates are made only if the data is accurate and relevant to the current system state. For instance, if a delivery truck reports an updated arrival time, this information is incorporated into the model during the synchronization phase to reflect the physical model's status accurately.

At step 312 of the method 300, the one or more hardware processors 204 of the system 200 are configured to simulate the synchronized digital twin of the physical model with one or more simulation scenarios, using a trained reinforcement learning (RL) agent. The one or more simulation scenarios are the target goals or target requirements of the company associated with one or more target goals of the physical model. Thus, the one or more simulation scenarios are used to generate the required parameter data by the trained reinforcement learning (RL) agent to simulate the synchronized digital twin of the physical model.

The usage of the digital twin involves testing various operational scenarios to assess performance and identify areas for improvement. The scenarios are defined based on operational needs and historical data. In an embodiment, the domain experts gather their insights on potential scenarios, which may include "What-if" analyses, such as a sudden increase in demand or vehicle breakdowns. Further, historical operational data is mined to identify patterns and trends. Techniques like clustering algorithms are employed to find common delivery issues that occurred, which can inform new scenarios.

Abnormal Situation Identification: The time-series data and anomaly detection techniques are utilized to identify unintentional or abnormal situations from historical records. By analyzing patterns in the data, we can automatically flag situations that deviate from the norm, using algorithms like Seasonal-Trend decomposition. For identified scenarios, the corresponding interventions are developed.

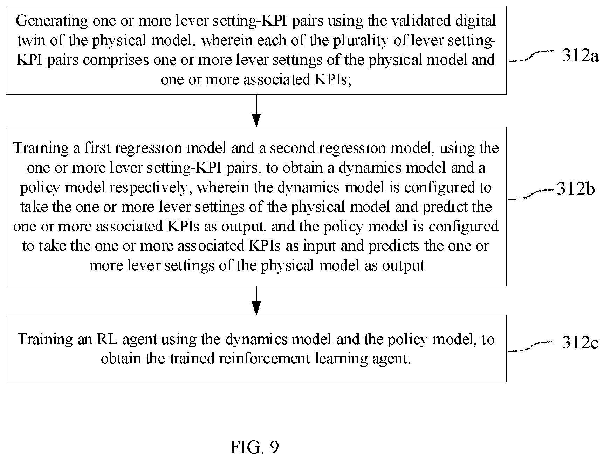

The reinforcement learning techniques are leveraged to determine the optimal interventions for specific scenarios. The algorithm can explore various intervention strategies and learn from historical outcomes to identify what works best in similar situations. FIG. 9 is a flow diagram showing steps for obtaining the trained RL agent, in accordance with some embodiments of the present disclosure. As shown in FIG. 9, obtaining the trained RL agent is explained through steps 312a to 312c. At step 312a, one or more lever setting-KPI pairs are generated using the validated digital twin of the physical model. Each of the plurality of lever setting-KPI pairs includes one or more lever settings of the physical model and one or more associated KPIs. The data of the one or more lever setting-KPI pairs is collected and normalized by applying standardization to ensure a consistent scale, improving model performance, to obtain the data. The data is then divided into training, validation, and test sets for model evaluation and to prevent overfitting.

At step 312b, a first regression model and a second regression model are trained using the one or more lever setting-KPI pairs, to obtain a dynamics model and a policy model respectively. The dynamics model is configured to take the one or more lever settings of the physical model and predict the one or more associated KPIs as output. The policy model is configured to take the one or more associated KPIs as input and predict the one or more lever settings of the physical model as output. Then at step 312c, an RL agent is trained using the dynamics model and the policy model, to obtain the trained reinforcement learning agent.

In an embodiment, the first regression model and the second regression model are the deep neural network based regression models which are initialized using PyTorch. Training the dynamics model is performed on lever-KPI pairs using Mean Squared Error (MSE) loss, adjusting weights to reduce prediction error. This model serves as a fast approximation of the simulator, predicting KPIs based on lever settings. Then, the policy model is setup with KPI goals as inputs and predicts lever settings to achieve these goals. Training the policy model reverse the input-output structure (feed KPI goals as inputs and lever settings as outputs) using PyTorch and minimize Mean Squared Error (MSE) between predicted and actual lever values. This model provides a head start for the RL agent by learning optimal lever-KPI relationships in advance.

Optimization of lever settings is performed using reinforcement learning by initializing the reinforcement learning agent with pretrained policy and dynamics models, leveraging transfer learning to give it a head start. Wherein, at the start of each episode the environment is reset and specific KPI targets are set. Wherein, in episode loop, the RL agent selects lever adjustments (actions) based on the current state and policy model. The lever adjustments are applied by retrieving new KPI values from the dynamics model or simulator. The reward is calculated based on reducing KPI error, with a penalty for large lever changes to encourage efficient adjustments. Wherein, agent policy is refined by using past actions and outcomes. At the end episode if KPI goals are met within a tolerance threshold, the episode ends. Otherwise, it continues until the maximum steps are reached. The policy model is validated regularly using PyTorch on new, unseen KPI goals to ensure generalization. After training, the policy model is used to meet specific KPI goals, providing optimized lever settings and validated KPIs within the required accuracy range.

Running Simulations: With scenarios defined and interventions structured, we proceed to simulate these operational scenarios. The instantiation of the metamodel is set reflecting the current state of operations and the newly defined scenarios. Using the simulation, the baseline model reflecting current operations and the associated algorithm for each scenario is developed.

Simulating Outcomes: For each scenario, the simulations are run to evaluate potential outcomes. The simulation engine iterates through various configurations and applies the defined interventions, allowing us to assess their impacts on delivery efficiency, costs, and timely parcel deliveries.

Analyzing Results: The results from the simulations undergo thorough analysis:
- The outcomes are visualized focusing on metrics such as delivery times, resource utilization, and operational costs.
- Any notable trends or insights gathered from these results guide refinements to the model or interventions.

Feedback & Refinement: Once simulations are analyzed, the outcomes can lead to refinements in the system.

Continuous Improvement: Based on simulation results, areas needing adjustment are identified. For example, vehicle routes refinement, adjusting inventory at Warehouses, and enhancing sorting processes based on recommendations from simulation analysis.

Updating Real-World Values: After achieving optimal configurations, these changes in the real-world operations are implemented. This includes updating route plans, recalibrating inventory levels, and informing operational staff about new best practices based on the simulation outcomes. A feedback loop is established to continuously assess the impact of implemented changes. New operational data is fed back into the system, allowing for constant monitoring and adaptation of the digital twin to reflect real-world dynamics accurately.

Through these steps of synchronization, usage and scenario generation, running simulations, and refinement, it is ensured that the digital twin of the physical model is not only accurate but also actively facilitates improved decision-making. The entire system adapts dynamically to operational realities, enhancing overall efficiency and effectiveness across the delivery network.

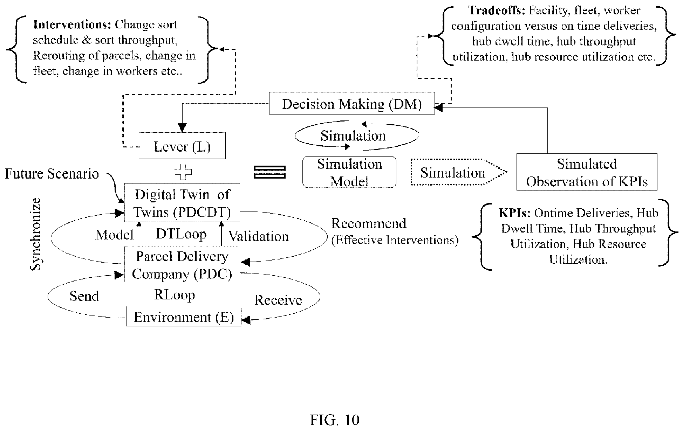

Thus, the present disclosure adopts a concept of composite digital-twin-based, an advanced agent-based modeling and simulation technique for quantitative analysis, and in-silico scenario explorations considering the entire physical model or the network. FIG. 10 is a schematic view of the digital twin of the physical model along with simulation approach, in accordance with some embodiments of the present disclosure. As shown in FIG. 10, the proposed approach considers two loops: the reality loop (RLoop) and the digital twin loop (DTLoop). The RLoop represents the real interactions between the parcel delivery company (PDC) and its environment (E). These interactions include the sending and receiving of parcels by individuals, companys, and other PDCs. The DTLoop is an in-silico loop for system understanding and exploring what-if scenarios that include comprehending the potential causes for bottlenecks, predicting future trends, and evaluating the efficacies of potential interventions. The key contributions of the present disclosure are the construction of a digital twin of PDC (termed as PDCDT) and establishing necessary links with RLoop to adequately replicate the PDC, and also leveraging PDCDT effectively towards informed decision-making.

Conforming to the method of the present disclosure for applying the digital twin concept in decision-making of socio-technoeconomic systems (Barat et al. 2022), a 4-step process is followed to construct and use PDCDT. The method starts with adequately modeling or mimicking the PDC and its environment into a simulatable agent model, which is termed as PDCM. A simulatable agent abstraction is employed that extends the canonical form of an agent (Agha et al. 1997). This simulatable form of the specification facilitates scenario explorations. The next step delves into the validation of PDCM, where conceptual validity and operational validity are employed. The conceptual validity is a qualitative step and is performed by explaining the model elements and their behaviors to domain experts and incorporating their views. Operational validity, on the other hand, is established by setting up the model to the historical state, simulating it with representative real interventions, and comparing simulated KPIs with system KPIs. Once the PCDM is validated, it is expected to be synchronized with the real system (i.e., data from RLoop). A link is set up to ensure the continued/on-demand synchronization of the digital model with the real system.

A validated and synchronized PCDM forms PDCDT. The PDCDT is leveraged to enable simulation loop to explore different means (referred to as levers) to understand the root cause of bottlenecks and explore potential solutions to address them. A wide spectrum of levers can be evaluated by introducing levers (L) to PDCDT and comparing simulated KPIs through multiple simulation runs. After exploring potential levers, the best lever, set of levers, or sequence of levers can be recommended to the PDC. This helps address resilience-related criteria. The same simulation loop is used for adaptation-related explorations, where possible disruptions and future scenarios can be emulated by conceptualizing future scenarios as levers and populating the PDCM with the future state, to explore effective adaptation-related interventions. Example Scenario:

Experimentation: The simulation capability of the agent-based model of the present disclosure is essential for conducting what-if analyses to achieve resilience and adaptation-related criteria. By synchronizing the constructed PDCM with real data from RLoop and simulating PDCDT, possible bottlenecks and disruptions in PDC can be understood along with their root causes. Moreover, levers can be configured to represent disrupted situations, and observation of simulated KPIs can help understand the impact of disruptions on PDC. For example, the impacts of traffic congestion or facility breakdowns on overall PDN performance can be experimented with for developing proactive strategies and mitigating risks from such disruptions. Furthermore, by simulating hypothetical scenarios and assessing their impact on KPIs such as on-time delivery rates or resource utilization, the approach of the present disclosure facilitates informed decision-making for enhancing adaptation capability.

The digital twin constructed by the present disclosure and supporting simulation capability can explore changes in both network structure and policies. This includes the ability to explore different types of facilities and fleets, create new network formations using new paths, and modify the core structure by adding or removing hubs. From a policy perspective, the simulation allows for the exploration of new trails, different resource allocation strategies, and various sorting logic effectively. Moreover, the simulation helps to understand the impact of these changes not only within the localized context but also across the entire network. This is achieved by observing KPIs associated with local entities such as facilities and fleets, as well as the global context represented by the KPIs associated with the PDC agent. Through multiple explorations and comparisons, we can establish trade-offs and identify globally optimal solutions.

Implementation: An actor/agent-based language, ESL (Clark et al. 2017), was employed to define the PDCM in a format suitable for simulation, and in the process of making it commercially available. Interfaces were developed using Excel sheets and a user-friendly user interface (UI) to configure the PDC, including parameters such as the number of facilities and fleets, their attributes, and paths. Additionally, four data extraction and injection plugins were employed to capture the states of parcels, fleets, facilities, and resources. These plugins serve for synchronization between the real system and the PDCDT, specifically connecting the RLoop to DTLoop.

Experimentation: The state-of-the-possibilities of the present disclosure was illustrated using a large-scale parcel delivery company (PDCX) that aims to improve on-time parcel delivery (which is related to customer satisfaction) while enhancing the utilization of facilities and resources (i.e., using operational costs effectively). Here, the digital twin was constructed first to represent the as-is system of PDCX. Next, a disruption was introduced by emulating the arrival of high-volume parcels representing the festive session. Then, a series of interventions was explored to evaluate their effectiveness, showcasing the role of the constructed digital twin and its simulation capability in facilitating justification-backed informed decision-making.

Experimental Setup: The experimental setup for the study focuses on a subset of PDCX, specifically centered around a major hub facility (F1). This subset comprises 857 facilities, 26,194 distinct parcel trails, and an approximate parcel inflow of 90,000 parcels per day. The network was constructed by considering ground delivery with normal priority service. All involved facilities wand fleets were configured with values of the real facilities and fleets of PDC. Table 1 shows a few sample values for illustration (actual values are not shown due to confidentiality). The simulation period spans 30 days.

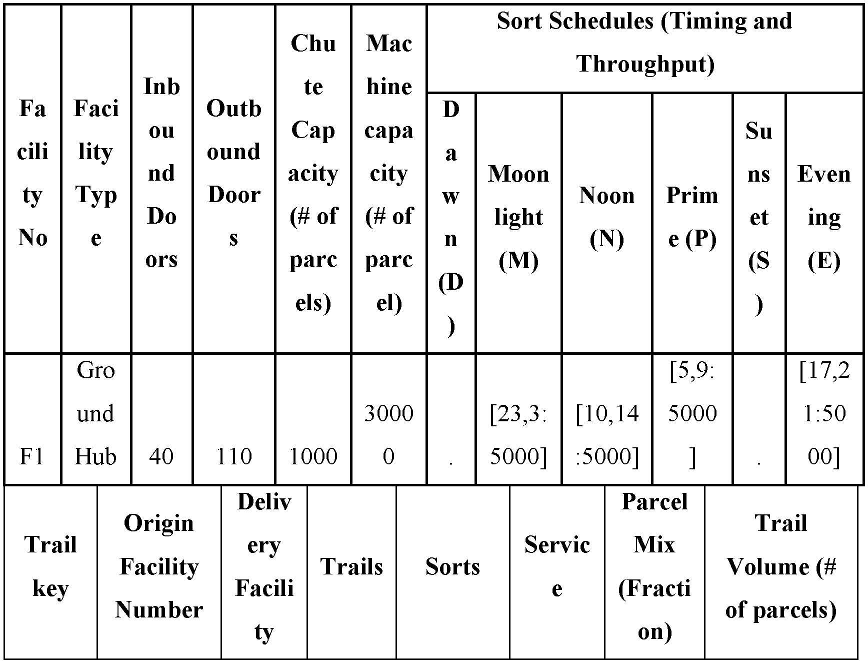

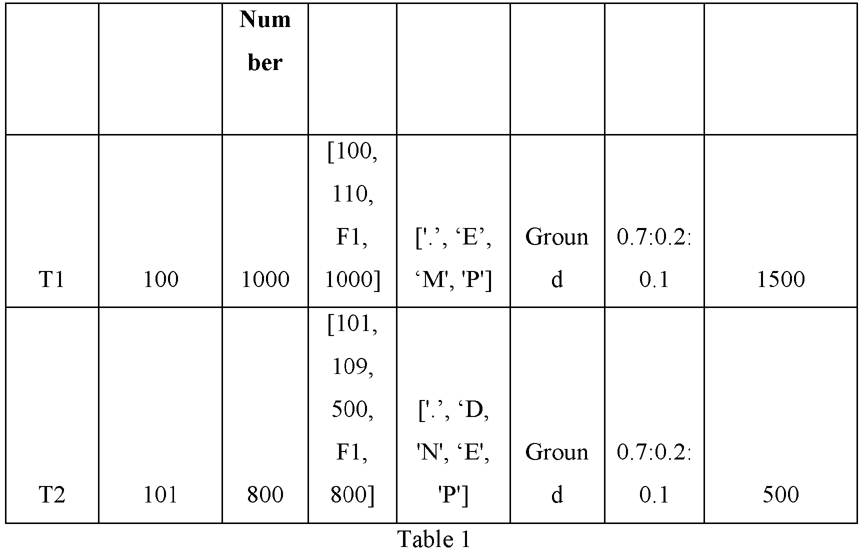

Experimentation: The experimentation encompassed a range of scenarios and interventions, all aimed at evaluating and improving KPIs of the PDC under different situations. Beginning with a baseline (as-is) scenario that represents the attribute values from the real system with regular business-as-usual operations, enabling a precise understanding of as-is system. Table. 2 shows the observations. Subsequently, a disruption (Scenario 1) was introduced, where the volume of selected parcel trails is increased by 5-10 times, which accounts to almost 38% of total parcel volume flowing through facility F1, to simulate peak periods and heightened parcel flows within the PDN. This scenario aims to evaluate the capacity of the PDC when demand is increased and identify any resulting bottlenecks or performance issues.

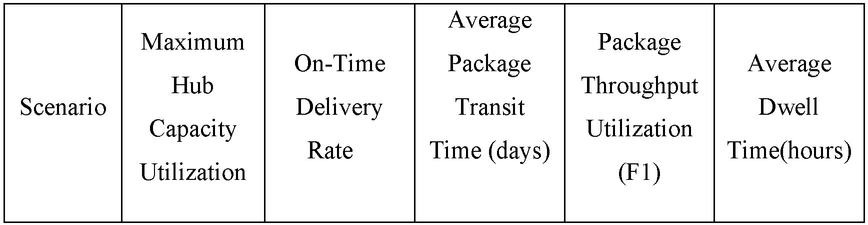

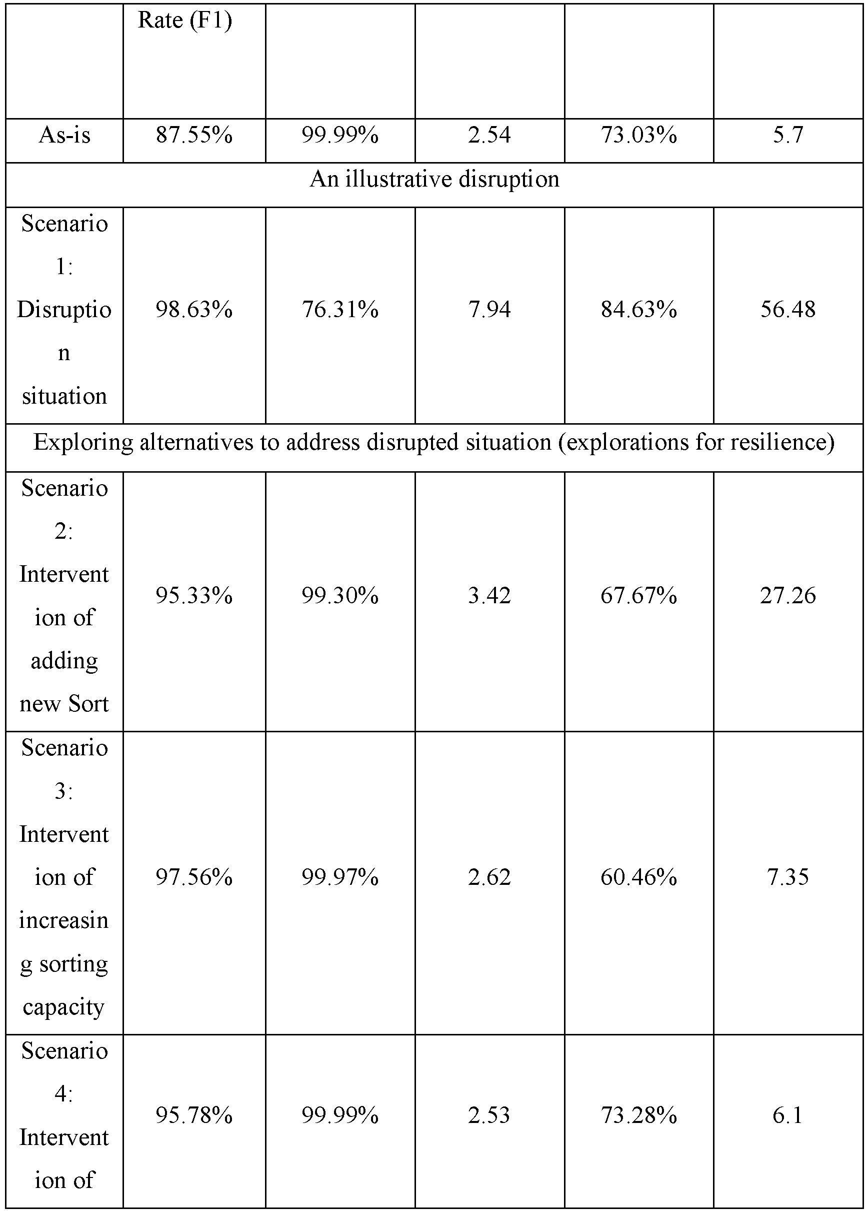

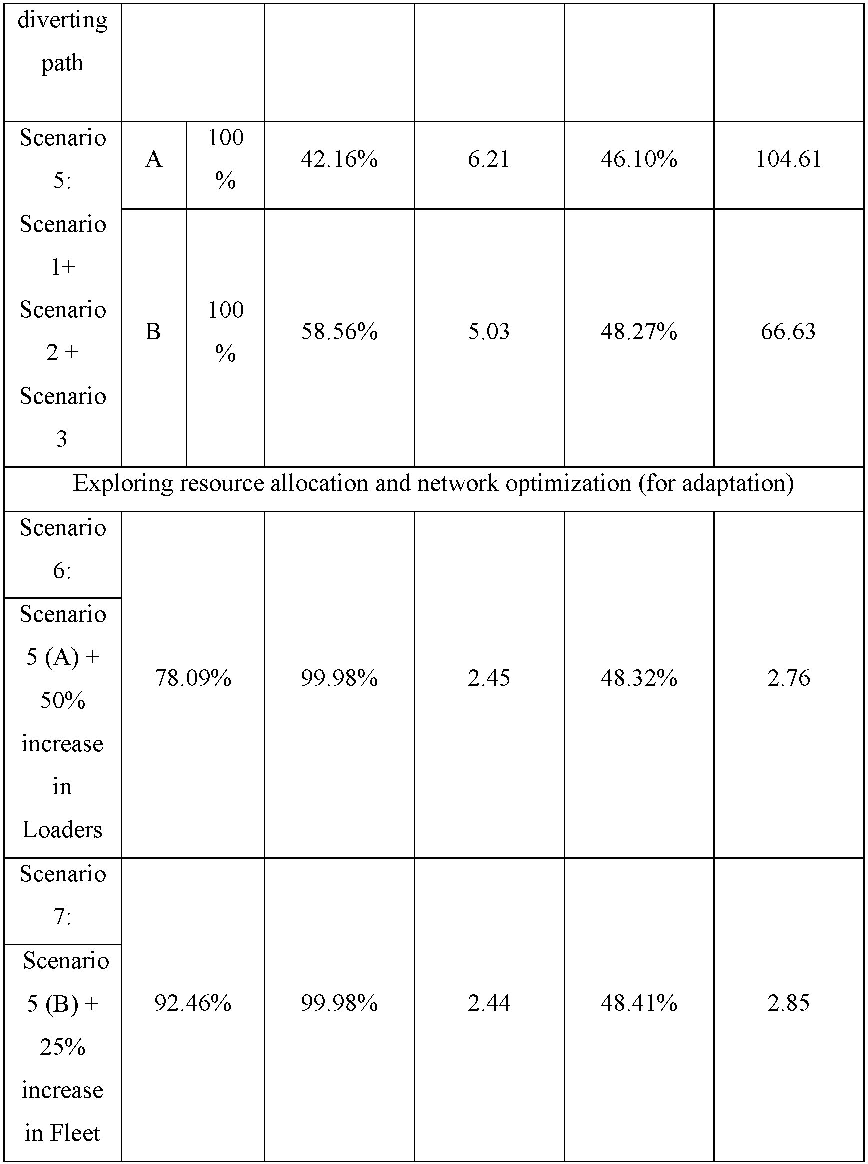

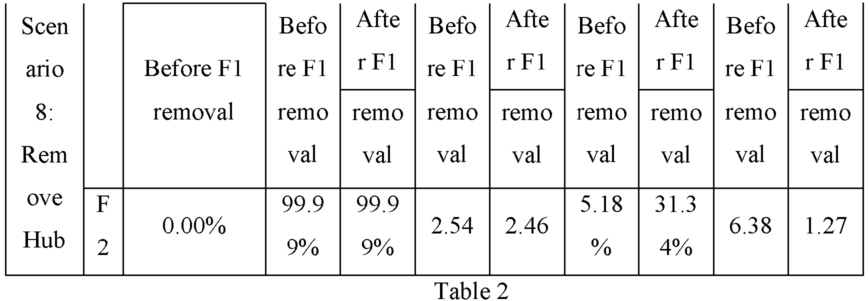

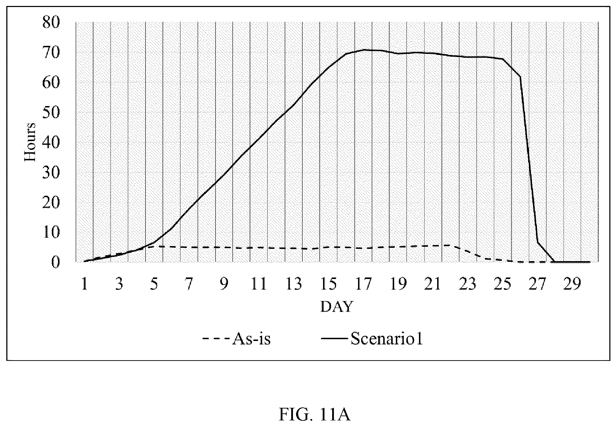

Comparing the "As Is" and "Disruption Scenarios" unveiled significant deviations in key performance indicators (KPIs). Notably, an increase in dwell time under the disruption scenario was observed due to congestion caused by the inflated parcel flow, by 8 times the time taken in as-is scenario. FIG. 11A is a graph showing parcel dwell time comparison of as-is and scenario 1, in accordance with some embodiments of the present disclosure.

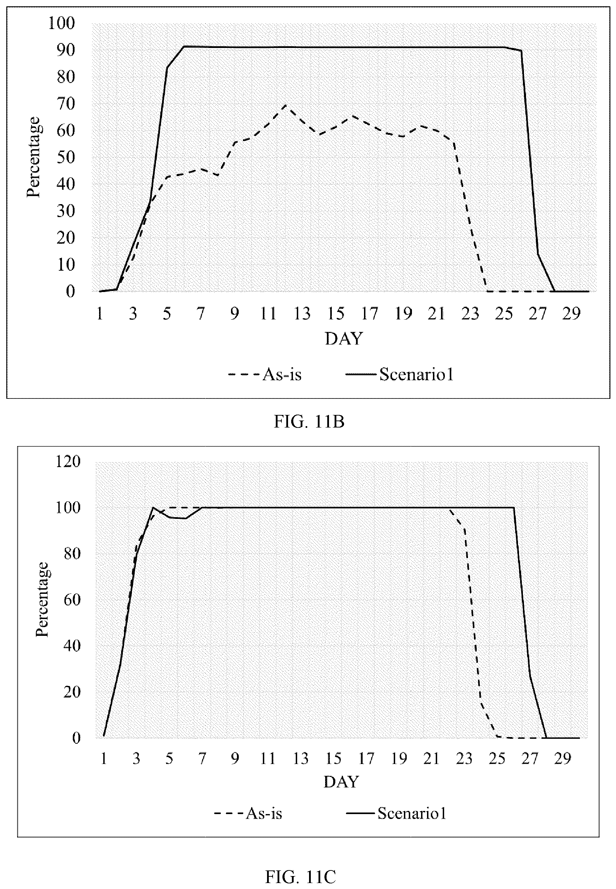

Additionally, FIG. 11B is a graph showing sort machine utilization comparison of as-is and scenario 1, in accordance with some embodiments of the present disclosure. As shown in FIG. 11B, the sort machine of facility F1 experienced strain during peak periods, leading to almost 100% capacity utilization. FIG. 11C is a graph showing sort machine throughput comparison of as-is and scenario 1, in accordance with some embodiments of the present disclosure. In the disruption scenario, the throughput utilization of facility F1 (in FIG. 11C), indicates that the sort machine ran for extended durations, reaching maximum throughput consistently, compared to the as-is scenario where the machines operated at the same maximum throughput but for a shorter duration.

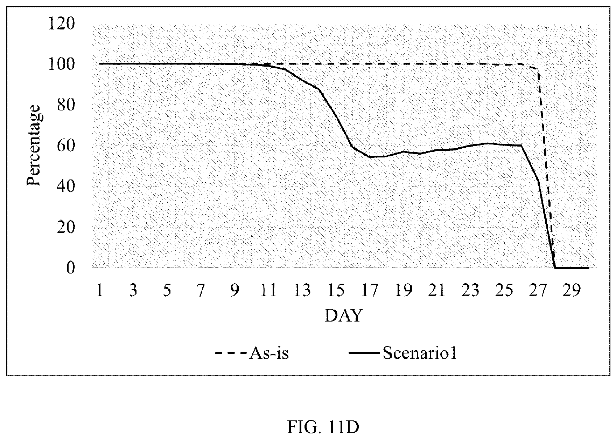

Moreover, the disruption scenario demonstrated adverse effects on on-time delivery metrics by a huge decrement of almost 23% over a period of 30 days, highlighting the PDC's decreased ability to meet delivery deadlines during periods of heightened demand. FIG. 11D is a graph showing on-time delivery comparison of as-is and scenario 1, in accordance with some embodiments of the present disclosure. This decline in performance underscored the presence of bottlenecks within the PDC, impeding the smooth flow of parcel traffic and compromising operational efficiency.

Next, the exploration of alternative strategies was pursued to mitigate these disruptions by simulating multiple scenarios to achieve a balanced network and address the identified bottlenecks effectively. To adapt to the increased parcel inflow, new sorting schedules were introduced to optimize the utilization of sorting resources. We added an additional sort schedule of 4 hours at facility F1 aiming to distribute the parcel load more evenly across available sort schedules. This resulted an improvement in overall on time delivery rate by almost 22% and reduced dwell times by 50% (refer to Table 2).

It was observed that extending sorting machine throughput capacity beyond standard rate helps to expedite parcel processing and reduce bottlenecks in the sorting process, thereby mitigating delays in delivery timelines. When the sort machine throughput capacity at Facility F1 was extended by 15%, a notable improvement in overall parcel transit time and parcel dwell time at facility F1 was observed when compared to the previous scenarios. Furthermore, to address the challenges posed by overutilized facilities, the parcels were strategically rerouted to underutilized facilities for further processing.

By redistributing 90% of the inflated parcel volume flowing through facility F1 to underutilized facilities, it was sought to alleviate congestion and improve processing capacity in facilities experiencing high demand, thereby enhancing overall operational resilience. It was also observed that the machine capacity utilization decreased markedly, addressing previous issues of overuse and resulting in reductions in both dwell time and parcel transit time. Moreover, the overall delivery rate saw a significant increase as a direct consequence of these operational optimizations.

It was further explored alternative operational scenarios under resource constraints, by simulating two variations: Scenario (A), with a limited number of loaders, and Scenario (B), featuring a restricted fleet size, within the PDN. These simulations aimed to gauge the impact of resource limitations on operational performance. Augmenting loaders by 50% at facility F 1 addressed resource constraints, bolstering parcel processing capacity during peak periods and resulting in significant improvements in on-time delivery rate, parcel transit time, and dwell time compared to Scenario (A). Similarly, increasing the fleet count by 25% at facility F1 enhanced delivery capabilities, mitigating delays and enhancing timely delivery, leading to substantial improvements in on-time delivery rate, parcel transit time, and dwell time compared to Scenario (B). Identifying Facility F1 as overutilized within the PDN, strategically retired it and redirected parcel flows to an underutilized nearby facility, Facility F2 (refer to Table 2). Leveraging its underutilized capacity ensured a smooth transition of parcel flows and minimized disruptions, with favorable outcomes observed in network-level KPIs such as dwell time and facility-specific KPIs including capacity and throughput utilization for both facilities.

The methods and systems of the present disclosure are explained for the physical model of the PDN. However, the scope is not limited to any other supply chain networks and warehousing where the physical model is available.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of present disclosure herein address unresolved problems of constructing and simulating a digital twin of physical model such as PDN. Having analyzed the state of art and practice, the methods and systems of the present disclosure showed its inadequacy in addressing the key needs of adaptiveness and resilience for the parcel delivery industry. The methods and systems of the present disclosure posited the digital twin concept and supporting technology as a means to overcome these lacunae. The methods and systems of the present disclosure proposed the simulation-based data-driven justification-backed approach to evaluate existing strategy for meeting the stated goals and to identify suitable interventions if required.

The methods and systems of the present disclosure illustrated utility and efficacy of the proposed approach using a complex use case from real world. Several challenges were encountered in constructing a hi-fidelity purposive digital twin of the parcel delivery network under consideration. For example, the available information such as parcel characteristics, fleet utilization data, resource availability, and resource productivity metrics was at best partial and pertained to what has happened and not to what could have happened.

To overcome this limitation, the methods and systems of the present disclosure relied on domain knowledge to augment the existing information with a range of possibilities thus improving fidelity and completeness of the composite digital twin. Domain knowledge was able to ascertain correctness and completeness of the composite digital twin through a process of conceptual and operational validation. The digital twin thus validated was seen to be a significant advancement over analysis techniques that rely solely on past data for future predictions. The methods and systems of the present disclosure acknowledge the time-, effort- and intellect-intensive nature of digital twin construction process, and its vulnerability to the expertise of people involved.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means, and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor-implemented method (300), comprising:
receiving, via one or more input/output (I/O) interfaces, a domain knowledge, one or more company specific datasets, and one or more company specific documents associated with a physical model of a company, from a resource repository, wherein the domain knowledge comprises one or more domain knowledge resource documents and one or more insight documents (302);
constructing, via the one or more hardware processors, an agent meta model of the physical model from the domain knowledge using an agent-based modelling framework, wherein the agent meta model of the physical model comprises (i) one or more components, (ii) one or more subcomponents associated with each of the one or more components, and (iii) one or more relationships between the one or more components and between the one or more subcomponents associated with each of the one or more components (304);
constructing, via the one or more hardware processors, a digital twin of the physical model by instantiating and populating the agent meta model of the physical model, using the one or more company specific datasets, wherein the digital twin of the physical model comprises (i) the one or more components with one or more component values, (ii) the one or more subcomponents associated with each of the one or more components along with one or more sub component values, and (iii) the one or more relationships between the one or more components and between the one or more subcomponents associated with each of the one or more components along with one or more relationship values (306);
validating, via the one or more hardware processors, a structure of the digital twin of the physical model through one or more automated structural validation techniques, to obtain a validated digital twin of the physical model (308);
synchronizing, via the one or more hardware processors, the validated digital twin of the physical model with a current status data of the physical model, to obtain a synchronized digital twin of the physical model (310); and
simulating, via the one or more hardware processors, the synchronized digital twin of the physical model with one or more simulation scenarios, using a trained reinforcement learning (RL) agent, wherein the one or more simulation scenarios are associated with one or more target goals of the physical model (312).

2. The processor-implemented method (300) as claimed in claim 1, wherein constructing the agent meta model of the physical model from the domain knowledge using an agent-based modelling framework, comprises:
identifying (i) the one or more components and (ii) the one or more subcomponents associated with each of the one or more components associated with the physical model, from the domain knowledge (304a);
extracting the one or more relationships between (i) the one or more components, and (ii) the one or more subcomponents associated with each of the one or more components, from the domain knowledge (304b); and
constructing the agent meta model of the physical model from (i) the one or more components, (ii) the one or more subcomponents associated with each of the one or more components, and (iii) the one or more relationships between the one or more components, and the one or more subcomponents associated with each of the one or more components, using the agent-based modelling framework (304c).

3. The processor-implemented method (300) as claimed in claim 1, wherein constructing the digital twin of the physical model by instantiating and populating the agent meta model of the physical model, comprises:
instantiating each of (i) the one or more components, (ii) the one or more sub-components, and (iii) the one or more relationships, at a time, in a sequential process (306a);
extracting (i) one or more component property values for each of the one or more components, (ii) one or more sub-component property values for each of the one or more sub-components, and (iii) a relationship value for each of the one or more relationships, from the one or more company specific datasets and the one or more company specific documents, using a pre-configured large language model (LLMs) (306b); and
populating (i) the one or more component property values for each of the one or more components, (ii) the one or more sub-component property values for each of the one or more sub-components, and (iii) the relationship value for each of the one or more relationships, into the agent meta model of the physical model, to obtain the digital twin of the physical model (306c).

4. The processor-implemented method (300) as claimed in claim 1, wherein validating the structure of the digital twin of the physical model through one or more automated structural validation techniques, comprises:
receiving a target structure and a target integrity of the physical model, from a repository (308a);
defining a set of validation rules related to (i) the target structure and the target integrity of the physical model, and (ii) the one or more relationships between the one or more components and between the one or more subcomponents associated with each of the one or more components, using the agent meta model of the physical model (308b); and
validating the structure of the digital twin of the physical model using the set of validation rules through one or more automated structural validation techniques, to obtain the validated digital twin of the physical model (308c).

5. The processor-implemented method (300) as claimed in claim 1, wherein synchronizing the validated digital twin of the physical model with the current status data of the physical model, comprises:
receiving the current status data of the physical model, wherein the current status data is associated with one or more parameters of the physical model (310a); and
initializing the validated digital twin of the physical model with the current status data, to obtain the synchronized digital twin of the physical model (310b).

6. The processor-implemented method (300) as claimed in claim 1, wherein the trained RL agent is obtained by:
generating one or more lever setting-KPI pairs using the validated digital twin of the physical model, wherein each of the plurality of lever setting-KPI pairs comprises one or more lever settings of the physical model and one or more associated KPIs (312a);
training a first regression model and a second regression model, using the one or more lever setting-KPI pairs, to obtain a dynamics model and a policy model respectively, wherein the dynamics model is configured to take the one or more lever settings of the physical model and predict the one or more associated KPIs as output, and the policy model is configured to take the one or more associated KPIs as input and predict the one or more lever settings of the physical model as output (312b); and
training an RL agent using the dynamics model and the policy model, to obtain the trained reinforcement learning agent (312c).

7. A system (200), comprising:
a memory (202) storing instructions;
one or more input/output (I/O) interfaces (206); and
one or more hardware processors (204) coupled to the memory (202) via the one or more I/O interfaces (206), wherein the one or more hardware processors (204) are configured by the instructions to:
receive via the one or more input/output (I/O) interfaces (206), a domain knowledge, one or more company specific datasets, and one or more company specific documents associated with a physical model of a company, from a resource repository, wherein the domain knowledge comprises one or more domain knowledge resource documents and one or more insight documents;
construct an agent meta model of the physical model from the domain knowledge using an agent-based modelling framework, wherein the agent meta model of the physical model comprises (i) one or more components, (ii) one or more subcomponents associated with each of the one or more components, and (iii) one or more relationships between the one or more components and between the one or more subcomponents associated with each of the one or more components;
construct a digital twin of the physical model by instantiating and populating the agent meta model of the physical model, using the one or more company specific datasets, wherein the digital twin of the physical model comprises (i) the one or more components with one or more component values, (ii) the one or more subcomponents associated with each of the one or more components along with one or more sub component values, and (iii) the one or more relationships between the one or more components and between the one or more subcomponents associated with each of the one or more components along with one or more relationship values;
validate a structure of the digital twin of the physical model through one or more automated structural validation techniques, to obtain a validated digital twin of the physical model;
synchronize the validated digital twin of the physical model with a current status data of the physical model, to obtain a synchronized digital twin of the physical model; and
simulate the synchronized digital twin of the physical model with one or more simulation scenarios, using a trained reinforcement learning (RL) agent, wherein the one or more simulation scenarios are associated with one or more target goals of the physical model.

8. The system (200) as claimed in claim 7, wherein the one or more hardware processors (204) are configured to construct the agent meta model of the physical model from the domain knowledge using an agent-based modelling framework, by:
identifying (i) the one or more components and (ii) the one or more subcomponents associated with each of the one or more components associated with the physical model, from the domain knowledge;
extracting the one or more relationships between (i) the one or more components, and (ii) the one or more subcomponents associated with each of the one or more components, from the domain knowledge; and
constructing the agent meta model of the physical model from (i) the one or more components, (ii) the one or more subcomponents associated with each of the one or more components, and (iii) the one or more relationships between the one or more components, and the one or more subcomponents associated with each of the one or more components, using the agent-based modelling framework.

9. The system (200) as claimed in claim 7, wherein the one or more hardware processors (204) are configured to construct the digital twin of the physical model by instantiating and populating the agent meta model of the physical model, by:
instantiating each of (i) the one or more components, (ii) the one or more sub-components, and (iii) the one or more relationships, at a time, in a sequential process;
extracting (i) one or more component property values for each of the one or more components, (ii) one or more sub-component property values for each of the one or more sub-components, and (iii) a relationship value for each of the one or more relationships, from the one or more company specific datasets and the one or more company specific documents, using a preconfigured large language model (LLMs); and
populating (i) the one or more component property values for each of the one or more components, (ii) the one or more sub-component property values for each of the one or more sub-components, and (iii) the relationship value for each of the one or more relationships, into the agent meta model of the physical model, to obtain the digital twin of the physical model.

10. The system (200) as claimed in claim 7, wherein the one or more hardware processors (204) are configured to validate the structure of the digital twin of the physical model through one or more automated structural validation techniques, by:
receiving a target structure and a target integrity of the physical model, from a repository;
defining a set of validation rules related to (i) the target structure and the target integrity of the physical model, and (ii) the one or more relationships between the one or more components and between the one or more subcomponents associated with each of the one or more components, using the agent meta model of the physical model; and
validating the structure of the digital twin of the physical model using the set of validation rules through one or more automated structural validation techniques, to obtain the validated digital twin of the physical model.

11. The system (200) as claimed in claim 7, wherein the one or more hardware processors (204) are configured to synchronize the validated digital twin of the physical model with the current status data of the physical model, by:
receiving the current status data of the physical model, wherein the current status data is associated with one or more parameters of the physical model; and
initializing the validated digital twin of the physical model with the current status data, to obtain the synchronized digital twin of the physical model.

12. The system (200) as claimed in claim 7, wherein the one or more hardware processors (204) are configured to obtain the trained RL agent, by:
generating one or more lever setting-KPI pairs using the validated digital twin of the physical model, wherein each of the plurality of lever setting-KPI pairs comprises one or more lever settings of the physical model and one or more associated KPIs;
training a first regression model and a second regression model, using the one or more lever setting-KPI pairs, to obtain a dynamics model and a policy model respectively, wherein the dynamics model is configured to take the one or more lever settings of the physical model and predict the one or more associated KPIs as output, and the policy model is configured to take the one or more associated KPIs as input and predict the one or more lever settings of the physical model as output; and
training an RL agent using the dynamics model and the policy model, to obtain the trained reinforcement learning agent.

13. One or more non-transitory machine-readable information storage mediums comprising one or more instructions which when executed by one or more hardware processors cause:
receiving a domain knowledge, one or more company specific datasets, and one or more company specific documents associated with a physical model of a company, from a resource repository, wherein the domain knowledge comprises one or more domain knowledge resource documents and one or more insight documents;
constructing an agent meta model of the physical model from the domain knowledge using an agent-based modelling framework, wherein the agent meta model of the physical model comprises (i) one or more components, (ii) one or more subcomponents associated with each of the one or more components, and (iii) one or more relationships between the one or more components and between the one or more subcomponents associated with each of the one or more components;
constructing a digital twin of the physical model by instantiating and populating the agent meta model of the physical model, using the one or more company specific datasets, wherein the digital twin of the physical model comprises (i) the one or more components with one or more component values, (ii) the one or more subcomponents associated with each of the one or more components along with one or more sub component values, and (iii) the one or more relationships between the one or more components and between the one or more subcomponents associated with each of the one or more components along with one or more relationship values;
validating a structure of the digital twin of the physical model through one or more automated structural validation techniques, to obtain a validated digital twin of the physical model;
synchronizing the validated digital twin of the physical model with a current status data of the physical model, to obtain a synchronized digital twin of the physical model; and
simulating the synchronized digital twin of the physical model with one or more simulation scenarios, using a trained reinforcement learning (RL) agent, wherein the one or more simulation scenarios are associated with one or more target goals of the physical model.
